(19) Europäisches Patentamt
European Patent Office
Office européen des brevets

(11) EP 4 291 001 A1

(12) EUROPEAN PATENT APPLICATION

(43) Date of publication:
**13.12.2023 Bulletin 2023/50**

(21) Application number: **23178303.6**

(22) Date of filing: **08.06.2023**

(51) International Patent Classification (IPC):
***H10K 50/11*** *(2023.01)* *H10K 101/00* *(2023.01)*
*H10K 50/18* *(2023.01)*

(52) Cooperative Patent Classification (CPC):
**H10K 50/11; H10K 50/18; H10K 50/181;**
H10K 85/346; H10K 2101/90

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **09.06.2022 KR 20220070204**

(71) Applicant: **Samsung Display Co., Ltd.**
**Yongin-si, Gyeonggi-do 17113 (KR)**

(72) Inventors:
- **SOHN, Jiho**
**Yongin-si, 17113 (KR)**
- **MUN, Sungjin**
**Yongin-si, 17113 (KR)**
- **SEO, Jihyun**
**Yongin-si, 17113 (KR)**
- **LEE, Jae Young**
**Yongin-si, 17113 (KR)**
- **LEE, Junyoung**
**Yongin-si, 17113 (KR)**
- **IM, Jahyun**
**Yongin-si, 17113 (KR)**
- **JEON, Sangho**
**Yongin-si, 17113 (KR)**

(74) Representative: **Taor, Simon Edward William et al**
**Venner Shipley LLP**
**200 Aldersgate**
**London EC1A 4HD (GB)**

# (54) LIGHT EMITTING DIODE AND DISPLAY DEVICE INCLUDING THE SAME

(57) A light emitting diode and a display device including the light emitting diode are provided. The light emitting diode may include a first electrode (EL1), a hole transport region (HTR) disposed on the first electrode, an emission auxiliary layer (A-EM) disposed on the hole transport region, a first buffer layer (BFL-1) disposed on the emission auxiliary layer, an emission layer disposed on the first buffer layer and including a hole transport host, an electron transport host, and a dopant having a dipole moment of about 2.0 Debye (D) or less, a second buffer layer (BFL-2) disposed on the emission layer, an electron transport region (ETR) disposed on the second buffer layer, and a second electrode (EL2) disposed on the electron transport region.

FIG. 3B

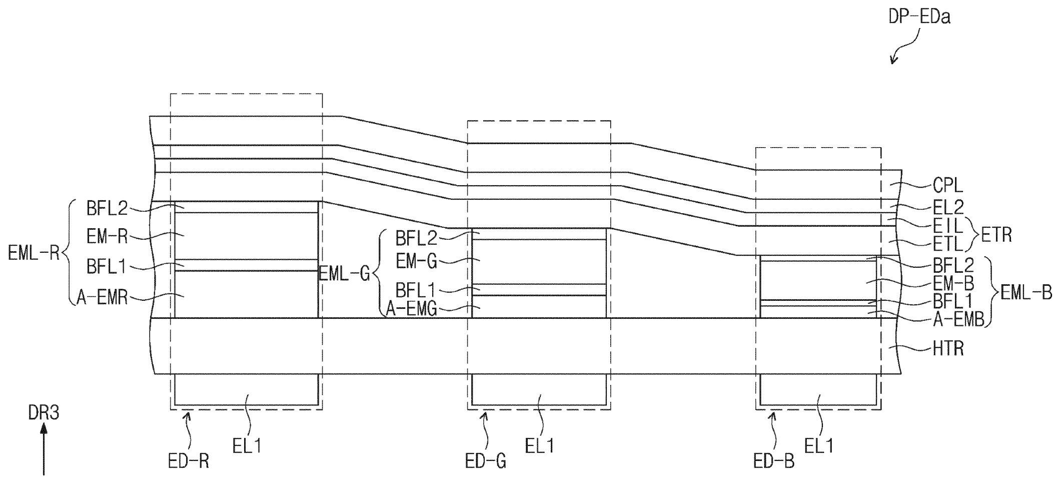


EP 4 291 001 A1

## Description

### CROSS-REFERENCE TO RELATED APPLICATION

This application claims priority to and the benefit of Korean Patent Application No. 10-2022-0070204, filed on June 9, 2022, in the Korean Intellectual Property Office.

### BACKGROUND

One or more aspects of embodiments of the present disclosure are directed to a light emitting diode and a display device including the same, and particularly, to a light emitting diode ameliorating the deterioration of display quality occurring during operation for a long time, and a display device including the same.
Various display devices utilized in multimedia devices such as televisions, mobile phones, tablet computers, navigations and game consoles are being developed. In such display devices, a so-called self-luminescent display diode achieving display by illuminating a light emitting material including an organic compound or quantum dots in an emission layer disposed between oppositely disposed electrodes, is utilized.
Light emitting diodes may induce damage by inverse current during driving for a long time, and resultant deterioration of display quality may arise. Therefore, development for ameliorating the display quality deterioration, including poor burn-in defects due to the utilization for a long time, is being actively conducted.

### SUMMARY

One or more aspects of embodiments of the present disclosure are directed toward a light emitting diode showing excellent or suitable diode properties even after driving for a long time.
one or more aspects of embodiments of the present disclosure are directed toward a display device showing excellent or suitable display quality through maintaining the capacitance characteristics of a light emitting diode even after driving for a long time.
Additional aspects will be set forth in part in the description which follows and, in part, will be apparent from the description, or may be learned by practice of the presented embodiments of the disclosure.
One or more embodiments of the present disclosure provide a light emitting diode including: a first electrode; a hole transport region disposed on the first electrode; an emission auxiliary layer disposed on the hole transport region; a first buffer layer disposed on the emission auxiliary layer; an emission layer disposed on the first buffer layer and including a hole transport host, an electron transport host, and a dopant; a second buffer layer disposed on the emission layer; an electron transport region disposed on the second buffer layer; and a second electrode disposed on the electron transport region, wherein a dipole moment of the dopant is about 2.0 Debye (D) or less.
In one or more embodiments, a highest occupied molecular orbital (HOMO) energy level of the first buffer layer may be lower than a HOMO energy level of the emission auxiliary layer.
In one or more embodiments, the HOMO energy level of the first buffer layer may be substantially equal to or higher than a HOMO energy level of the hole transport host of the emission layer.
In one or more embodiments, a difference between the HOMO energy level of the first buffer layer and the HOMO energy level of the emission auxiliary layer may be greater than a difference between the HOMO energy level of the first buffer layer and the HOMO energy level of the hole transport host of the emission layer.
In one or more embodiments, a HOMO energy level of the first buffer layer may be about -4.97 eV to about -4.80 eV.
In one or more embodiments, a lowest unoccupied molecular orbital (LUMO) energy level of the second buffer layer may be higher than a LUMO energy level of the electron transport host of the emission layer.
In one or more embodiments, a LUMO energy level of the electron transport region may be substantially equal to or lower than the LUMO energy level of the second buffer layer.
In one or more embodiments, a LUMO energy level of the second buffer layer may be about -1.94 eV to about -1.70 eV.
In one or more embodiments, the dopant may be an organometallic complex including Pt as a central metal.
In one or more embodiments, the emission layer may be to emit green light.
In one or more embodiments, the first buffer layer may be disposed directly between the emission auxiliary layer and the emission layer, and the second buffer layer may be disposed directly on the emission layer.
According to one or more embodiments of the present disclosure, there is provided a display device including a plurality of light emitting diodes emitting different wavelength regions of light, wherein each of the plurality of light emitting diodes may include: a first electrode; a hole transport region disposed on the first electrode; an emission structure disposed on the hole transport region and including an emission layer; an electron transport region disposed on the

emission structure; and a second electrode disposed on the electron transport region, wherein the emission layer in at least one emission structure in the light emitting diodes, may include a hole transport host, an electron transport host, and a dopant, where a dipole moment of the dopant is about 2.0 D or less.

In one or more embodiments, the at least one emission structure may further include: an emission auxiliary layer disposed on the hole transport region; a first buffer layer disposed between the emission auxiliary layer and the emission layer; and a second buffer layer disposed between the emission layer and the electron transport region.

In one or more embodiments, a HOMO energy level of the first buffer layer may be substantially equal to or higher than a HOMO energy level of the hole transport host of the emission layer and may be lower than a HOMO energy level of the emission auxiliary layer.

In one or more embodiments, a difference between the HOMO energy level of the first buffer layer and the HOMO energy level of the emission auxiliary layer may be greater than a difference between the HOMO energy level of the first buffer layer and the HOMO energy level of the hole transport host of the emission layer.

In one or more embodiments, a LUMO energy level of the second buffer layer may be higher than a LUMO energy level of the electron transport host.

In one or more embodiments, a LUMO energy level of the electron transport region may be substantially equal to or higher than the LUMO energy level of the electron transport host.

According to one or more embodiments of the present disclosure, there is provided a display device including a red light emitting diode emitting red light, a green light emitting diode emitting green light, and a blue light emitting diode emitting blue light, wherein the green light emitting diode may include a first electrode, a hole transport region, an emission structure, an electron transport region, and a second electrode, stacked in order (e.g., in the stated order), the emission structure may include a hole transport host, an electron transport host, and a dopant, where a dipole moment of the dopant is about 2.0 D or less.

In one or more embodiments, the emission structure may further include: an emission auxiliary layer disposed on the hole transport region; a first buffer layer disposed directly between the emission auxiliary layer and the emission layer; and a second buffer layer disposed directly between the emission layer and the electron transport region.

In one or more embodiments, a HOMO energy level of the first buffer layer may be substantially equal to or higher than a HOMO energy level of the hole transport host and may be lower than a HOMO energy level of the emission auxiliary layer.

In one or more embodiments, a LUMO energy level of the second buffer layer may be higher than a LUMO energy level of the electron transport host and a LUMO energy level of the electron transport region.

In one or more embodiments, the dopant may be an organometallic complex including Pt as a central metal.

According to an aspect, there is provided a light emitting diode as set out in claim 1. Additional features are set out in claims 2 to 9. According to an aspect, there is provided a display device as set out in claim 10. Additional features are set out in claims 11 to 15.

## BRIEF DESCRIPTION OF THE FIGURES

The accompanying drawings are included to provide a further understanding of the present disclosure and are incorporated in and constitute a part of this specification. The drawings illustrate embodiments of the present disclosure and, together with the description, serve to explain principles of the present disclosure. Above and/or other aspects of the present disclosure will become apparent and appreciated from the following description of embodiments taken in conjunction with the accompanying drawings. In the drawings:

FIG. 1 is a plan view of a display device according to one or more embodiments of the present disclosure;
FIG. 2 is a cross-sectional view of a display device of one or more embodiments, corresponding to line I-I’ in FIG. 1;
FIG. 3A is a cross-sectional view showing a part of a display device according to one or more embodiments of the present disclosure;
FIG. 3B is a cross-sectional view showing a part of a display device according to one or more embodiments of the present disclosure;
FIG. 4 is a cross-sectional view showing a light emitting diode according to one or more embodiments of the present disclosure;
FIG. 5 is a diagram showing dipole moment and capacitance values in an Example and Comparative Examples according to one or more embodiments of the present disclosure;
FIG. 6A is a diagram showing an energy diagram in a light emitting diode according to one or more embodiments of the present disclosure;
FIG. 6B is a diagram showing an energy diagram in a light emitting diode of a comparative example according to one or more embodiments of the present disclosure;
FIG. 7 is a diagram showing charge density change in an Example and Comparative Example according to one or

more embodiments of the present disclosure;

FIG. 8 is a diagram showing capacitance change in an Example and Comparative Example according to one or more embodiments of the present disclosure;

FIG. 9 is a diagram showing capacitance change amount and display quality evaluation results in Examples and Comparative Example according to one or more embodiments of the present disclosure;

FIG. 10 is a diagram showing the initial values of capacitance and display quality evaluation results in Examples and Comparative Example according to one or more embodiments of the present disclosure;

FIG. 11 is a diagram showing an energy diagram in a light emitting diode according to one or more embodiments of the present disclosure;

FIG. 12 is a diagram showing capacitance according to the LUMO energy level of a second buffer layer according to one or more embodiments of the present disclosure; and

FIG. 13 is a diagram showing capacitance according to the LUMO energy level of an electron transport layer according to one or more embodiments of the present disclosure.

## DETAILED DESCRIPTION

The present disclosure may have one or more suitable modifications and may be embodied in different forms, and example embodiments will be explained in more detail with reference to the accompany drawings. The present disclosure may, however, be embodied in different forms and should not be construed as limited to the embodiments set forth herein. Rather, all modifications, equivalents, and substituents which are included in the technical scope of the present disclosure should be included in the present disclosure.

In the present disclosure, it will be understood that when an element (or region, layer, part, etc.) is referred to as being "on", "connected to" or "coupled to" another element, it can be directly on, connected or coupled to the other element or a third intervening elements may be present.

In some embodiments, "directly on" may refer to that there are no additional layers, films, regions, plates, etc., between a layer, a film, a region, a plate, etc. and the other part. For example, "directly on" may refer to two layers or two members are disposed without utilizing an additional member such as an adhesive member therebetween.

Like reference numerals may refer to like elements throughout the present disclosure, and duplicative descriptions thereof may not be provided for conciseness. In some embodiments, in the drawings, the thickness, the ratio, and the dimensions of constituent elements may be exaggerated for effective explanation of technical contents. The terms "and/or" and "or" may include one or more combinations which may be defined by relevant elements. Further, the utilization of "may" when describing embodiments of the present disclosure refers to "one or more embodiments of the present disclosure."

It will be understood that, although the terms first, second, etc. may be utilized herein to describe one or more suitable elements, these elements should not be limited by these terms. These terms are only utilized to distinguish one element from another element. For example, a first element could be termed a second element without departing from the teachings of the present disclosure. Similarly, a second element could be termed a first element. As utilized herein, the singular forms are intended to include the plural forms as well, unless the context clearly indicates otherwise.

In some embodiments, the terms "below," "beneath," "on," and "above" are utilized for explaining the relation of elements shown in the drawings. The terms are relative concept and are explained based on the direction shown in the drawing. In the present disclosure, when an element is referred to as being disposed "on" another element, it can be disposed under the other element.

Unless otherwise defined, all terms (including technical and scientific terms) utilized herein have the same meaning as commonly understood by one of ordinary skill in the art to which this present disclosure belongs. It will be further understood that terms, such as those defined in commonly utilized dictionaries, should be interpreted as having a meaning that is consistent with their meaning in the context of the relevant art and will not be interpreted in an idealized or overly formal sense unless expressly so defined herein.

In the present disclosure, it will be further understood that the terms "comprise(s)/include(s) " and/or "comprising/including," when utilized in the present disclosure, specify the presence of stated features, numerals, steps, operations, elements, parts, or the combination thereof, but do not preclude the presence or addition of one or more other features, numerals, steps, operations, elements, parts, or the combination thereof.

In the present disclosure, the term "substituted or unsubstituted" corresponds to substituted or unsubstituted with at least one substituent selected from the group consisting of deuterium, a halogen (e.g., F, Cl, Br, I, etc.), a cyano group, a nitro group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, an alkoxy group, a hydrocarbon ring group, an aryl group, and a heterocyclic group. In some embodiments, each of the exemplified substituents may be substituted or unsubstituted. For example, a biphenyl group may be interpreted as an aryl group, or a phenyl group substituted with a phenyl group.

In the present disclosure, the term "forming a ring via the combination with an adjacent group" may refer to forming a substituted or unsubstituted hydrocarbon ring, or a substituted or unsubstituted heterocycle via the combination with an adjacent group. The hydrocarbon ring may include an aliphatic hydrocarbon ring and an aromatic hydrocarbon ring. The heterocycle may include an aliphatic heterocycle and an aromatic heterocycle. The hydrocarbon ring and the heterocycle may be monocycles or polycycles. In some embodiments, the ring formed via the combination with an adjacent group may be combined with another ring to form a spiro structure.

In the present disclosure, the term "adjacent group" may refer to a substituent substituted for an atom which is directly combined with an atom substituted with a corresponding substituent, another substituent substituted for an atom which is substituted with a corresponding substituent, or a substituent sterically positioned at the nearest position to a corresponding substituent. For example, in 1,2-dimethylbenzene, two methyl groups may be interpreted as "adjacent groups" to each other, and in 1,1-diethylcyclopentene, two ethyl groups may be interpreted as "adjacent groups" to each other. For another example, in 4,5-dimethylphenanthrene, two methyl groups may be interpreted as "adjacent groups" to each other.

In the present disclosure, a halogen may be fluorine, chlorine, bromine, or iodine.

In the present disclosure, an alkyl group may be a linear, branched, or cyclic type or kind. The carbon number of the alkyl group may be 1 to 50, 1 to 30, 1 to 20, 1 to 10, or 1 to 6. Examples of the alkyl group may include methyl, ethyl, n-propyl, isopropyl, n-butyl, s-butyl, t-butyl, i-butyl, 2-ethylbutyl, 3,3-dimethylbutyl, n-pentyl, i-pentyl, neopentyl, t-pentyl, cyclopentyl, 1-methylpentyl, 3-methylpentyl, 2-ethylpentyl, 4-methyl-2-pentyl, n-hexyl, 1-methylhexyl, 2-ethylhexyl, 2-butylhexyl, cyclohexyl, 4-methylcyclohexyl, 4-t-butylcyclohexyl, n-heptyl, 1-methylheptyl, 2,2-dimethylheptyl, 2-ethylheptyl, 2-butylheptyl, n-octyl, t-octyl, 2-ethyloctyl, 2-butyloctyl, 2-hexyloctyl, 3,7-dimethyloctyl, cyclooctyl, n-nonyl, n-decyl, adamantyl, 2-ethyldecyl, 2-butyldecyl, 2-hexyldecyl, 2-octyldecyl, n-undecyl, n-dodecyl, 2-ethyldodecyl, 2-butyldodecyl, 2-hexyldocecyl, 2-octyldodecyl, n-tridecyl, n-tetradecyl, n-pentadecyl, n-hexadecyl, 2-ethylhexadecyl, 2-butylhexadecyl, 2-hexylhexadecyl, 2-octylhexadecyl, n-heptadecyl, n-octadecyl, n-nonadecyl, n-eicosyl, 2-ethyleicosyl, 2-butyleicosyl, 2-hexyleicosyl, 2-octyleicosyl, n-henicosyl, n-docosyl, n-tricosyl, n-tetracosyl, n-pentacosyl, n-hexacosyl, n-heptacosyl, n-octacosyl, n-nonacosyl, n-triacontyl, etc., without limitation.

In the present disclosure, an alkenyl group may refer to a hydrocarbon group including one or more carbon-carbon double bonds in the middle or at the terminal of an alkyl group having a carbon number of 2 or more. The alkenyl group may be a linear chain or a branched chain. The carbon number of the alkenyl group is not specifically limited, but may be 2 to 30, 2 to 20, or 2 to 10. Examples of the alkenyl group may include a vinyl group, a 1-butenyl group, a 1-pentenyl group, a 1,3-butadienyl group, a styrenyl group, a styrylvinyl group, etc., without limitation.

In the present disclosure, an alkynyl group may refer to a hydrocarbon group including one or more carbon-carbon triple bonds in the middle or at the terminal of an alkyl group having a carbon number of 2 or more. The alkynyl group may be a linear chain or a branched chain. The carbon number of the alkynyl is not specifically limited, but may be 2 to 30, 2 to 20, or 2 to 10. Examples of the alkynyl group may include an ethynyl group, a propynyl group, etc., without limitation.

In the present disclosure, a hydrocarbon ring group may refer to an optional functional group or substituent derived from an aliphatic hydrocarbon ring. The hydrocarbon ring group may be a saturated hydrocarbon ring group of 5 to 20 ring-forming carbon atoms.

In the present disclosure, an aryl group may refer to an optional functional group or substituent derived from an aromatic hydrocarbon ring. The aryl group may be a monocyclic aryl group or a polycyclic aryl group. The carbon number for forming rings in the aryl group may be 6 to 30, 6 to 20, or 6 to 15. Examples of the aryl group may include phenyl, naphthyl, fluorenyl, anthracenyl, phenanthryl, biphenyl, terphenyl, quaterphenyl, quinquephenyl, sexiphenyl, triphenylenyl, pyrenyl, benzofluoranthenyl, chrysenyl, etc., without limitation.

In the present disclosure, a fluorenyl group may be substituted, and two substituents may be combined with each other to form a spiro structure. Examples of a substituted fluorenyl group are as follows, but embodiments of the present disclosure are not limited thereto.

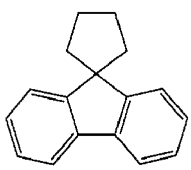 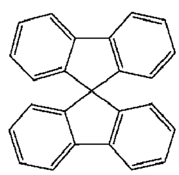 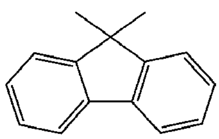 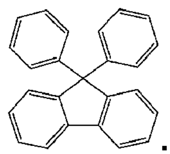.

In the present disclosure, a heterocyclic group may refer to an optional functional group or substituent derived from a ring including one or more selected from among B, O, N, P, Si, and S as heteroatoms. The heterocyclic group may include an aliphatic heterocyclic group and an aromatic heterocyclic group. The aromatic heterocyclic group may be a heteroaryl group. The aliphatic heterocyclic group and the aromatic heterocyclic group may be a monocycle or a

polycycle.

When the heterocyclic group includes two or more heteroatoms, the two or more heteroatoms may be the same or different. The heterocyclic group may be a monocyclic heterocyclic group or a polycyclic heterocyclic group, and has the concept including a heteroaryl group. The carbon number for forming rings in the heterocyclic group may be 2 to 30, 2 to 20, and 2 to 10.

In the present disclosure, an aliphatic heterocyclic group may include one or more selected from among B, O, N, P, Si, and S as heteroatoms. The number of ring-forming carbon atoms in the aliphatic heterocyclic group may be 2 to 30, 2 to 20, or 2 to 10. Examples of the aliphatic heterocyclic group may include an oxirane group, a thiirane group, a pyrrolidine group, a piperidine group, a tetrahydrofuran group, a tetrahydrothiophene group, a thiane group, a tetrahydropyran group, a 1,4-dioxane group, etc., without limitation.

In the present disclosure, a heteroaryl group may include one or more selected from among B, O, N, P, Si, and S as heteroatoms. When the heteroaryl group includes two or more heteroatoms, the two or more heteroatoms may be the same or different. The heteroaryl group may be a monocyclic heterocyclic group or polycyclic heterocyclic group. The carbon number for forming rings in the heteroaryl group may be 2 to 30, 2 to 20, or 2 to 10. Examples of the heteroaryl group may include thiophene, furan, pyrrole, imidazole, triazole, pyridine, bipyridine, pyrimidine, triazine, acridyl, pyridazine, pyrazinyl, quinoline, quinazoline, quinoxaline, phenoxazine, phthalazine, pyrido pyrimidine, pyrido pyrazine, pyrazino pyrazine, isoquinoline, indole, carbazole, N-arylcarbazole, N-heteroarylcarbazole, N-alkylcarbazole, benzoxazole, benzimidazole, benzothiazole, benzocarbazole, benzothiophene, dibenzothiophene, thienothiophene, benzofuran, phenanthroline, thiazole, isooxazole, oxazole, oxadiazole, thiadiazole, phenothiazine, dibenzosilole, dibenzofuran, etc., without limitation.

In the present disclosure, the same explanation on the above-described aryl group may be applied to an arylene group except that the arylene group is a divalent group. The same explanation on the above-described heteroaryl group may be applied to a heteroarylene group except that the heteroarylene group is a divalent group.

In the present disclosure, a boron group may refer to the above-defined alkyl group or aryl group, combined with a boron atom. The boron group may include an alkyl boron group and an aryl boron group. Examples of the boron group may include a dimethylboron group, a diethylboron group, a t-butylmethylboron group, a diphenylboron group, a phenylboron group, etc., without limitation.

In the present disclosure, a silyl group may include an alkyl silyl group and an aryl silyl group. Examples of the silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, etc., without limitation.

In the present disclosure, the carbon number of a carbonyl group is not specifically limited, but the carbon number may be 1 to 40, 1 to 30, or 1 to 20. For example, the carbonyl group may have the structures below, but is not limited thereto.

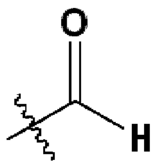
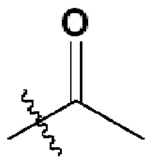
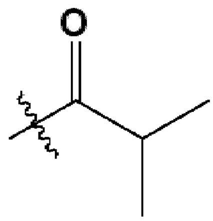
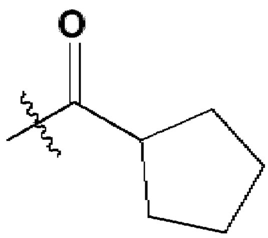
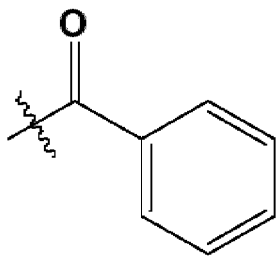
.

In the present disclosure, the carbon number of a sulfinyl group and sulfonyl group is not specifically limited, but may be 1 to 30. The sulfinyl group may include an alkyl sulfinyl group and an aryl sulfinyl group. The sulfonyl group may include an alkyl sulfonyl group and an aryl sulfonyl group.

In the present disclosure, a thio group may include an alkyl thio group and an aryl thio group. The thio group may refer to the above-defined alkyl group or aryl group combined with a sulfur atom. Examples of the thio group may include a methylthio group, an ethylthio group, a propylthio group, a pentylthio group, a hexylthio group, an octylthio group, a dodecylthio group, a cyclopentylthio group, a cyclohexylthio group, a phenylthio group, a naphthylthio group, etc., without limitation.

In the present disclosure, an oxy group may refer to the above-defined alkyl group or aryl group which is combined with an oxygen atom. The oxy group may include an alkoxy group and an aryl oxy group. The alkoxy group may be a linear, branched, or cyclic chain. The carbon number of the alkoxy group is not specifically limited but may be, for example, 1 to 20 or 1 to 10. Non-limiting examples of the oxy group may include methoxy, ethoxy, n-propoxy, isopropoxy, butoxy, pentyloxy, hexyloxy, octyloxy, nonyloxy, decyloxy, benzyloxy, etc. However, embodiments of the present disclosure are not limited thereto.

In the present disclosure, the carbon number of an amine group is not specifically limited, but may be 1 to 30. The amine group may include an alkyl amine group and an aryl amine group. Examples of the amine group may include a methylamine group, a dimethylamine group, a phenylamine group, a diphenylamine group, a naphthylamine group, a 9-methyl-anthracenylamine group, etc., without limitation.

In the present disclosure, alkyl groups in an alkoxy group, alkylthio group, alkylsulfinyl group, alkylsulfonyl group, alkylaryl group, alkylamino group, alkylboron group, alkyl silyl group, and alkyl amine group may be the same as the examples of the above-described alkyl group.

In the present disclosure, aryl groups in an aryloxy group, arylthio group, arylsulfinyl group, aryl sulfonyl group, aryl amino group, arylboron group, aryl silyl group, and aryl amine group may be the same as the examples of the above-described aryl group.

In the present disclosure, a direct linkage may refer to a single bond.

In the present disclosure, " 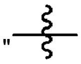 ", or "-*" may refer to a position to be connected.

Hereinafter, a light emitting diode according to one or more embodiments of the present disclosure and a display device including the same will be explained in more detail referring to the drawings.

FIG. 1 is a plan view of a display device DD according to one or more embodiments of the present disclosure. FIG. 2 is a cross-sectional view of a display device DD according to one or more embodiments of the present disclosure. FIG. 2 is a cross-sectional view showing a part of a display device DD, corresponding to line I-I' in FIG. 1.

The display device DD may include a display panel DP and an optical layer PP disposed on the display panel DP. The display panel DP includes light emitting diodes ED-R, ED-G, and ED-B. The display device DD may include a plurality of light emitting diodes ED-R, ED-G, and ED-B. An optical layer PP may be disposed on the display panel DP and control reflected light by external light at the display panel DP. The optical layer PP may include, for example, a polarization layer or a color filter layer. In some embodiments, different from the drawings, the optical layer PP may not be provided in the display device DD.

On the optical layer PP, a base layer BL may be disposed. The base layer BL may be a member providing a base surface where the optical layer PP is disposed. The base layer BL may be a glass substrate, a metal substrate, a plastic substrate, etc. However, embodiments of the present disclosure are not limited thereto, and the base layer BL may be an inorganic layer, an organic layer, or a composite material layer. In some embodiments, different from the drawings, the base layer BL may not be provided.

The display panel DP may include a base substrate BS, a circuit layer DP-CL disposed on the base substrate BS, a display diode layer DP-ED disposed on the circuit layer DP-CL, and an encapsulation layer TFE disposed on the display diode layer DP-ED. The display diode layer DP-ED may include a pixel definition layer PDL, light emitting diodes ED-R, ED-G, and ED-B disposed in the pixel definition layer PDL.

The base substrate BS may be a member providing a base surface where the display diode layer DP-ED is disposed. The base substrate BS may be a glass substrate, a metal substrate, a plastic substrate, etc. However, embodiments of the present disclosure are not limited thereto, and the base substrate BS may be an inorganic layer, an organic layer, or a composite material layer.

In one or more embodiments, the circuit layer DP-CL is disposed on the base substrate BS, and the circuit layer DP-CL may include a plurality of transistors. Each of the transistors may include a control electrode, an input electrode, and an output electrode. For example, the circuit layer DP-CL may include switching transistors and driving transistors for driving the light emitting diodes ED-R, ED-G, and ED-B of the display diode layer DP-ED.

In one or more embodiments, each of the light emitting diodes ED-R, ED-G, and ED-B may include a first electrode EL1, a hole transport region HTR, a respective one from among emission structures EML-R, EML-G, and EML-B, an electron transport region ETR, and a second electrode EL2. In some embodiments, the light emitting diodes ED-R, ED-G, and ED-B may further include a capping layer CPL disposed on the second electrode EL2. Each of the emission structures EML-R, EML-G, and EML-B may include a plurality of layers.

In FIG. 2, shown is an embodiment where the emission structures EML-R, EML-G, and EML-B of the light emitting diodes ED-R, ED-G, and ED-B, respectively, are disposed in opening portions OH defined in a pixel definition layer PDL, and a hole transport region HTR, an electron transport region ETR, and a second electrode EL2 are provided as common layers in all light emitting diodes ED-R, ED-G, and ED-B. However, embodiments of the present disclosure are not limited thereto. Different from FIG. 2, in one or more embodiments, the hole transport region HTR and the electron transport region ETR may be patterned and provided in the opening portions OH defined in the pixel definition layer PDL. For example, in one or more embodiments, the hole transport region HTR, the emission structures EML-R, EML-G, and EML-B, and the electron transport region ETR of the light emitting diodes ED-R, ED-G, and ED-B may be patterned by an inkjet printing method and provided.

An encapsulation layer TFE may be disposed on the light emitting diodes ED-R, ED-G, and ED-B. The encapsulation layer TFE may encapsulate the display diode layer DP-ED. The encapsulation layer TFE may be a thin film

encapsulation layer. The encapsulation layer TFE may be one layer or a stacked layer of a plurality of layers. The encapsulation layer TFE may include at least one insulating layer. In some embodiments, the encapsulation layer TFE may include at least one inorganic layer (hereinafter, encapsulating inorganic layer). In some embodiments, the encapsulation layer TFE may include at least one organic layer (hereinafter, encapsulating organic layer) and at least one encapsulating inorganic layer.

The encapsulating inorganic layer protects the display diode layer DP-ED from moisture/oxygen, and the encapsulating organic layer protects the display diode layer DP-ED from foreign materials such as dust particles. In some embodiments, the encapsulating inorganic layer may include silicon nitride, silicon oxy nitride, silicon oxide, titanium oxide, aluminum oxide, or one or more combinations thereof, without specific limitation. In some embodiments, the encapsulating organic layer may include an acrylic compound, an epoxy-based compound, etc. In some embodiments, the encapsulating organic layer may include a photopolymerizable organic material, without specific limitation.

The encapsulation layer TFE may be disposed on the second electrode EL2 and may be disposed while filling the opening portion OH.

In one or more embodiments, the display device DD may further include a plugging layer. The plugging layer may be disposed between the encapsulation layer TFE and the base layer BL. The plugging layer may be an organic material layer. The plugging layer may include at least one selected from among an acrylic resin, a silicone-based resin, and an epoxy-based resin.

Referring to FIG. 1 and FIG. 2, the display device DD may include a non-luminous area NPXA and luminous areas PXA-R, PXA-G, and PXA-B. The luminous areas PXA-R, PXA-G, and PXA-B may be areas emitting light produced from the light emitting diodes ED-R, ED-G, and ED-B, respectively. The luminous areas PXA-R, PXA-G, and PXA-B may be separated from each other on a plane.

The luminous areas PXA-R, PXA-G, and PXA-B may be areas separated by the pixel definition layer PDL. The non-luminous areas NPXA may be areas between neighboring luminous areas PXA-R, PXA-G, and PXA-B and may be areas corresponding to the pixel definition layer PDL. In some embodiments of the present disclosure, each of the luminous areas PXA-R, PXA-G, and PXA-B may correspond to each pixel. The pixel definition layer PDL may divide the light emitting diodes ED-R, ED-G, and ED-B. The emission structures EML-R, EML-G, and EML-B of the light emitting diodes ED-R, ED-G, and ED-B may be disposed and divided in the opening portions OH defined in the pixel definition layer PDL.

The luminous areas PXA-R, PXA-G, and PXA-B may be divided into a plurality of groups according to the color of light produced from the light emitting diodes ED-R, ED-G, and ED-B. In one or more embodiments, in the display device DD, shown in FIG. 1 and FIG. 2, three luminous areas PXA-R, PXA-G, and PXA-B, emitting red light, green light, and blue light, respectively, are illustrated. For example, in some embodiments, the display device DD may include a red luminous area PXA-R, a green luminous area PXA-G, and a blue luminous area PXA-B, which are separated from each other.

In one or more embodiments, in the display device DD, a plurality of light emitting diodes ED-R, ED-G, and ED-B may be to emit light having different wavelength regions. For example, in some embodiments, the display device DD may include a first light emitting diode ED-R emitting red light, a second light emitting diode ED-G emitting green light, and a third light emitting diode ED-B emitting blue light. For example, the red luminous area PXA-R, the green luminous area PXA-G, and the blue luminous area PXA-B of the display device DD may correspond to the first light emitting diode ED-R, the second light emitting diode ED-G, and the third light emitting diode ED-B, respectively.

However, embodiments of the present disclosure are not limited thereto, for example, the first to third light emitting diodes ED-R, ED-G, and ED-B may be to emit light in substantially the same wavelength region, or at least one thereof may be to emit light in a different wavelength region.

In one or more embodiments, the luminous areas PXA-R, PXA-G, and PXA-B in the display device DD may be arranged in a stripe shape. Referring to FIG. 1, in some embodiments, a plurality of red luminous areas PXA-R may be arranged with each other along a second direction axis DR2, a plurality of green luminous areas PXA-G may be arranged with each other along the second direction axis DR2, and a plurality of blue luminous areas PXA-B may be arranged with each other along the second direction axis DR2. In some embodiments, the red luminous areas PXA-R, the green luminous areas PXA-G, and the blue luminous areas PXA-B may be arranged by turns along a first direction axis DR1.

In FIG. 1 and FIG. 2, the areas of the luminous areas PXA-R, PXA-G, and PXA-B are shown similar, but embodiments of the present disclosure are not limited thereto. The areas of the luminous areas PXA-R, PXA-G, and PXA-B may be different from each other according to the wavelength region of light emitted. In some embodiments, the areas of the luminous areas PXA-R, PXA-G, and PXA-B may refer to areas on a plane defined by the first direction axis DR1 and the second direction axis DR2.

In some embodiments, the arrangement type or kind of the luminous areas PXA-R, PXA-G, and PXA-B is not limited to the configuration shown in FIG. 1, and the arrangement order of the red luminous areas PXA-R, the green luminous areas PXA-G, and the blue luminous areas PXA-B may be provided in one or more suitable combinations

according to the properties of display quality required for the display device DD. For example, the arrangement type or kind of the luminous areas PXA-R, PXA-G, and PXA-B may be a pentile (PENTILE®) arrangement type or kind (for example, an RGBG matrix, an RGBG structure, or an RGBG matrix structure), or a diamond (Diamond Pixel™) arrangement type or kind. (e.g., a display (e.g., an OLED display) containing red, blue, and green (RGB) luminous areas arranged in the shape of diamonds). PENTILE® is a duly registered trademark of Samsung Display Co., Ltd. Diamond Pixel™ is a trademark of Samsung Display Co., Ltd.

In some embodiments, the areas of the luminous areas PXA-R, PXA-G, and PXA-B may be different from each other. For example, in one embodiment, the area of the green luminous area PXA-G may be smaller than the area of the blue luminous area PXA-B, but embodiments of the present disclosure are not limited thereto.

FIG. 3A and FIG. 3B are cross-sectional views showing parts of the display device according one or more embodiments of the present disclosure. FIG. 4 is a cross-sectional view showing a light emitting diode according to one or more embodiments of the present disclosure.

In FIG. 3A, a display diode layer DP-ED in the display device according to one or more embodiments of the present disclosure is schematically shown. In FIG. 3A, only the configuration of the light emitting diodes ED-R, ED-G, and ED-B excluding the pixel definition layer PDL (FIG. 2) is shown.

Referring to FIG. 3A, the display diode layer DP-ED may include a first light emitting diode ED-R, a second light emitting diode ED-G, and a third light emitting diode ED-B, emitting different wavelengths of light. The first light emitting diode ED-R may be a red light emitting diode emitting red light, the second light emitting diode ED-G may be a green light emitting diode emitting green light, and the third light emitting diode ED-B may be a blue light emitting diode emitting blue light. However, the light emitted from each of the light emitting diodes ED-R, ED-G, and ED-B is not limited to red, green, or blue.

Each of the first to third light emitting diodes ED-R, ED-G, and ED-B may include a first electrode EL1, a second electrode EL2 oppositely disposed to the first electrode EL1, a hole transport region HTR disposed between the first electrode EL1 and the second electrode EL2, emission structures EML-R, EML-G, and EML-B, respectively, and an electron transport region ETR. In some embodiments, the first to third light emitting diodes ED-R, ED-G, and ED-B may include a capping layer CPL disposed on the second electrode EL2, and the electron transport region ETR may include an electron transport layer ETL and an electron injection layer EIL.

The emission structures EML-R, EML-G, and EML-B may include emission layers EM-R, EM-G, and EM-B, respectively, emitting light, and auxiliary layers for improving the light efficiency and lifetime of the emission layers EM-R, EM-G, and EM-B.

In one or more embodiments, the emission structure EML-R of the first light emitting diode ED-R may include a first emission layer EM-R, and a first emission auxiliary layer A-EMR disposed on the lower side of the first emission layer EM-R (e.g., between the first emission layer EM-R and the hole transport region HTR). The second light emitting diode ED-G may include a second emission auxiliary layer A-EMG disposed on the lower side of a second emission layer EM-G (e.g., between the second emission layer EM-G and the hole transport region HTR), and the third light emitting diode ED-B may include a third emission auxiliary layer A-EMB disposed on the lower side of a third emission layer EM-B (e.g., between the third emission layer EM-B and the hole transport region HTR). In some embodiments, the third emission auxiliary layer A-EMB may not be provided. In some embodiments, the third emission structure EML-B may further include a buffer layer instead of the third emission auxiliary layer A-EMB.

In one or more embodiments, in the display diode layer DP-ED shown in FIG. 3A, the second light emitting diode ED-G may further include a first buffer layer BFL1 and a second buffer layer BFL2 in the emission structure EML-G. In some embodiments, different from FIG. 3A, in the display diode layer DP-ED, the second light emitting diode ED-G may further include any one selected from among a first buffer layer BFL1 and a second buffer layer BFL2 in the emission structure EML-G.

The first buffer layer BFL1 may be disposed between the second emission auxiliary layer A-EMG and the second emission layer EM-G, and the second buffer layer BFL2 may be disposed between the second emission layer EM-G and the electron transport region ETR. The first buffer layer BFL1 may control the density of holes transferred from the hole transport region HTR to the second emission layer EM-G, and the second buffer layer BFL2 may control the density of electrons transferred from the electron transport layer ETL to the second emission layer EM-G. The first buffer layer BFL1 may be disposed adjacent to the hole transport region HTR to reduce the accumulation of holes in the second emission layer EM-G, and the second buffer layer BFL2 may be disposed adjacent to the electron transport region ETR to reduce the accumulation of electrons in the second emission layer EM-G.

In one or more embodiments, for example, in the display device DD (FIG. 2), different from the first light emitting diode ED-R and the third light emitting diode ED-B, the second light emitting diode ED-G emitting green light among the plurality of light emitting diodes ED-R, ED-G, and ED-B, emitting different wavelengths of light in the display diode layer DP-ED, may further include the first buffer layer BFL1 and the second buffer layer BFL2. This is for improving luminescence excitation phenomenon in the second light emitting diode ED-G emitting green light during re-operation after driving the display diode layer DP-ED for a long time.

However, embodiments of the present disclosure are not limited thereto. Referring to FIG. 3B, in one or more embodiments, in a display diode layer DP-EDa, at least one selected from among a first buffer layer BFL1 and a second buffer layer BFL2 may be further included in a first light emitting diode ED-R and a third light emitting diode ED-B in addition to a second light emitting diode ED-G. The display diode layer DP-EDa shown in FIG. 3B is different from the display diode layer DP-ED shown in FIG. 3A in that the first buffer layer BFL1 and the second buffer layer BFL2 are included in both the first light emitting diode ED-R and the third light emitting diode ED-B. In FIG. 3B, all the first to third light emitting diodes ED-R, ED-G, and ED-B may include the first buffer layer BFL1 and the second buffer layer BFL2, but embodiments of the present disclosure are not limited thereto, and each of the first to third light emitting diodes ED-R, ED-G, and ED-B may include at least one selected from among the first buffer layer BFL1 and the second buffer layer BFL2. In some embodiments, though not shown in FIG. 3A and FIG. 3B, at least one selected from among the first buffer layer BFL1 and the second buffer layer BFL2 may be included in the second light emitting diode ED-G, and any one selected from among the first light emitting diode ED-R and the third light emitting diode ED-B.

The materials of the first buffer layer BFL1 and the second buffer layer BFL2, included in the first light emitting diode ED-R and the third light emitting diode ED-B may be changed according to the materials of the emission auxiliary layers A-EMR and A-EMB, and the emission layers EM-R and EM-B, utilized in each emission structures EML-R and EML-B. However, embodiments of the present disclosure are not limited thereto, and the first buffer layers BFL1 included in the first to third light emitting diodes ED-R, ED-G, and ED-B may utilize the same material, or the second buffer layers BFL2 included in the first to third light emitting diodes ED-R, ED-G, and ED-B may utilize the same material.

FIG. 4 shows the cross-sectional view of a light emitting diode according to one or more embodiments of the present disclosure, and at least one selected from among the light emitting diodes ED-R, ED-G, and ED-B, shown in FIG. 2 to FIG. 3B may have the structure of the light emitting diode ED shown in FIG. 4. For example, in one or more embodiments, the second light emitting diode ED-G may have the structure of the light emitting diode ED shown in FIG. 4.

In some embodiments, the same configuration of the light emitting diode ED explained referring to FIG. 4 may be applied to the first to third light emitting diodes ED-R, ED-G, and ED-B. However, embodiments of the present disclosure are not limited thereto, and the material of the emission layer EM, explained later may not be applied to the first light emitting diode to the third light emitting diode ED-R, ED-G, and ED-B, but different host materials and dopant materials may be included.

In one or more embodiments, the light emitting diode ED may include a first electrode EL1, a second electrode EL2 oppositely disposed to the first electrode EL1, and an emission structure EML disposed between the first electrode EL1 and the second electrode EL2. The light emitting diode ED may include a hole transport region HTR disposed between the first electrode EL1 and the emission structure EML, and an electron transport region ETR disposed between the emission structure EML and the second electrode EL2. In some embodiments, the light emitting diode ED may further include a capping layer CPL disposed on the second electrode EL2.

In one or more embodiments, the emission structure EML may include an emission auxiliary layer A-EM, a first buffer layer BFL1, an emission layer EM, and a second buffer layer BFL2. The first buffer layer BFL1 may be disposed directly under the emission layer EM, and the second buffer layer BFL2 may be disposed directly on the emission layer EM.

In one or more embodiments, in the light emitting diode ED, the first electrode EL1 has conductivity (e.g., is a conductor). The first electrode EL1 may be formed utilizing a metal material, a metal alloy, or a conductive compound. The first electrode EL1 may be an anode or a cathode. However, embodiments of the present disclosure are not limited thereto. In some embodiments, the first electrode EL1 may be a pixel electrode. The first electrode EL1 may be a transmissive electrode, a transflective electrode, or a reflective electrode. The first electrode EL1 may include at least one selected from among (silver) Ag, magnesium (Mg), copper (Cu), aluminum (Al), platinum (Pt), palladium (Pd), gold (Au), nickel (Ni), neodymium (Nd), iridium (Ir), chromium (Cr), lithium (Li), calcium (Ca), lithium fluoride (LiF), molybdenum (Mo), titanium (Ti), tungsten (W), indium (In), tin (Sn), and zinc (Zn), compounds of two or more selected therefrom, mixtures of two or more selected therefrom, and oxides thereof.

When the first electrode EL1 is the transmissive electrode, the first electrode EL1 may include a transparent metal oxide such as indium tin oxide (ITO), indium zinc oxide (IZO), zinc oxide (ZnO), and indium tin zinc oxide (ITZO). When the first electrode EL1 is the transflective electrode or the reflective electrode, the first electrode EL1 may include Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, one or more compounds thereof, or one or more mixtures thereof (for example, a mixture of Ag and Mg). In some embodiments, the first electrode EL1 may have a structure of a plurality of layers including a reflective layer or a transflective layer formed utilizing the above materials, and a transmissive conductive layer formed utilizing ITO, IZO, ZnO, or ITZO. For example, in some embodiments, the first electrode EL1 may have a three-layer structure of ITO/Ag/ITO. However, embodiments of the present disclosure are not limited thereto. In some embodiments, the first electrode EL1 may include one or more of the above-described metal materials, combinations of two or more metal materials selected from the above-described metal materials, and/or oxides of the above-described metal materials, without limitation. For example, in some embodiments, in the light emitting diode ED, ITO may be utilized as the first electrode EL1, and the highest occupied molecular orbital (HOMO) energy level of the ITO may be about -5.0 eV.

The thickness of the first electrode EL1 may be from about 700 Å to about 10,000 Å. For example, in one or more embodiments, the thickness of the first electrode EL1 may be from about 1,000 Å to about 3,000 Å.

In one or more embodiments, in the light emitting diode ED, the second electrode EL2 may be provided on the electron transport region ETR. The second electrode EL2 may be a common electrode. The second electrode EL2 may be a cathode or an anode, but embodiments of the present disclosure are not limited thereto. For example, when the first electrode EL1 is an anode, the second electrode EL2 may be a cathode, and when the first electrode EL1 is a cathode, the second electrode EL2 may be an anode. The second electrode may include at least one selected from among Ag, Mg, Cu, Al, Pt, Pd, Au, Ni, Nd, Ir, Cr, Li, Ca, LiF, Mo, Ti, W, In, Sn and Zn, compounds of two or more selected therefrom, mixtures of two or more selected therefrom, and oxides thereof.

The second electrode EL2 may be a transmissive electrode, a transflective electrode, or a reflective electrode. When the second electrode EL2 is the transmissive electrode, the second electrode EL2 may be formed utilizing a transparent metal oxide such as indium tin oxide (ITO), indium zinc oxide (IZO), zinc oxide (ZnO), and/or indium tin zinc oxide (ITZO).

When the second electrode EL2 is the transflective electrode or the reflective electrode, the second electrode EL2 may include Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, Yb (ytterbium), and/or one or more compounds or mixtures thereof (for example, AgMg, AgYb, or MgYb). In some embodiments, the second electrode EL2 may have a structure of a plurality of layers including a reflective layer and/or a transflective layer formed utilizing the above materials, and a transmissive conductive layer formed utilizing ITO, IZO, ZnO, and/or ITZO. For example, the second electrode EL2 may include one or more of the above-described metal materials, combinations of two or more metal materials selected from the above-described metal materials, and/or oxides of the above-described metal materials.

In one or more embodiments, the second electrode EL2 may be connected with an auxiliary electrode. When the second electrode EL2 is connected with the auxiliary electrode, the resistance of the second electrode EL2 may be reduced.

In some embodiments, on the second electrode EL2 in the light emitting diode ED, a capping layer CPL may be further disposed. The capping layer CPL may include a multilayer or a single layer.

In one or more embodiments, the capping layer CPL may be an organic layer and/or an inorganic layer. For example, when the capping layer CPL includes an inorganic material, the inorganic material may include an alkali metal compound such as LiF, an alkaline earth metal compound such as $MgF_2$, SiON, SiNx, SiOy, etc.

For example, when the capping layer CPL includes an organic material, the organic material may include α-NPD, NPB, TPD, m-MTDATA, $Alq_3$, CuPc, N4,N4,N4',N4'-tetra(biphenyl-4-yl) biphenyl-4,4'-diamine (TPD15), 4,4',4"-tris(carbazol - 9-yl) triphenylamine (TCTA), etc., or may include an epoxy resin, or acrylate such as methacrylate. In some embodiments, a capping layer CPL may include at least one selected from among Compounds P1 to P5, but embodiments of the present disclosure are not limited thereto.

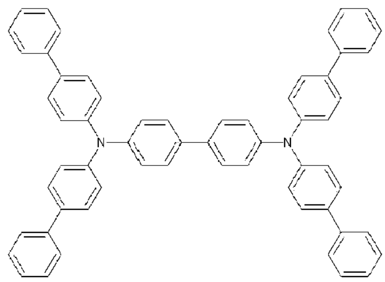

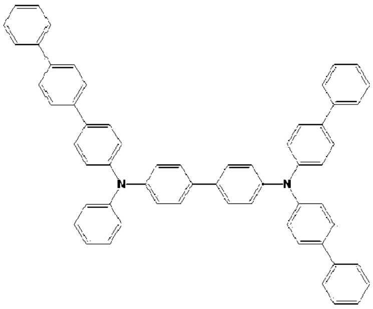

P1 P3

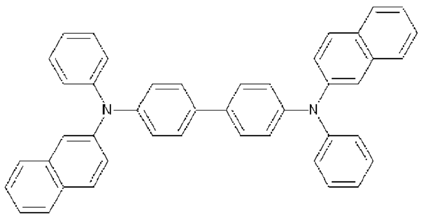

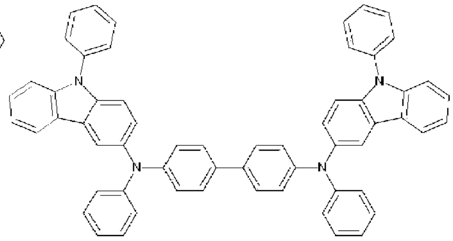

P2 P4

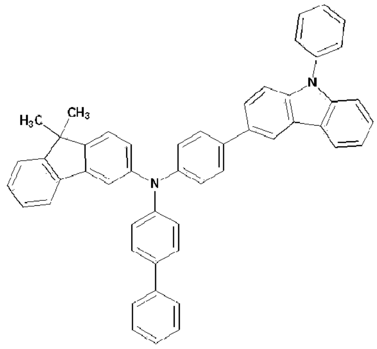

P5 .

In some embodiments, the refractive index of the capping layer CPL may be about 1.6 or more. For example, in some embodiments, the refractive index of the capping layer CPL with respect to light in a wavelength range of about 550 nm to about 660 nm may be about 1.6 or more.

In one or more embodiments, in the light emitting diode ED, the hole transport region HTR may be provided on the first electrode EL1. The hole transport region HTR may be disposed between the first electrode EL1 and the emission structure EML. The hole transport region HTR may have a single layer formed utilizing a single material, a single layer formed utilizing a plurality of different materials, or a multilayer structure including a plurality of layers formed utilizing a plurality of different materials.

The hole transport region HTR may include a hole injection layer HIL and a hole transport layer HTL. The hole transport region HTR may further include auxiliary layers in addition to the hole injection layer HIL and the hole transport layer HTL. For example, in some embodiments, the hole transport region HTR may further include an electron blocking layer disposed on the hole transport layer HTL.

In some embodiments, differently, the hole transport region HTR may have the structure of a single layer of a hole injection layer HIL or a hole transport layer HTL, and may have a structure of a single layer formed utilizing a hole injection material and a hole transport material. In some embodiments, the hole transport region HTR may have a structure of a single layer formed utilizing a plurality of unconventional materials, or a structure of a plurality of layers stacked from the first electrode EL1, but embodiments of the present disclosure are not limited thereto.

The thickness of the hole transport region HTR may be, for example, about 50 Å to about 15,000 Å. The hole transport region HTR may be formed utilizing one or more suitable methods such as a vacuum deposition method, a spin coating method, a cast method, a Langmuir-Blodgett (LB) method, an inkjet printing method, a laser printing method, and/or a laser induced thermal imaging (LITI) method.

The hole transport region HTR may include a compound represented by Formula H-1.

### Formula H-1

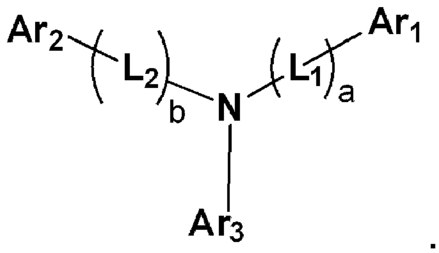

In Formula H-1, $L_1$ and $L_2$ may each independently be a direct linkage, a substituted or unsubstituted arylene group of 6 to 30 ring-forming carbon atoms, or a substituted or unsubstituted heteroarylene group of 2 to 30 ring-forming carbon atoms. "a" and "b" may each independently be an integer of 0 to 10. In some embodiments, when "a" or "b" is an integer of 2 or more, a plurality of $L_1$ and $L_2$ may each independently be a substituted or unsubstituted arylene group of 6 to 30 ring-forming carbon atoms, or a substituted or unsubstituted heteroarylene group of 2 to 30 ring-forming carbon atoms.

In Formula H-1, $Ar_1$ and $Ar_2$ may each independently be a substituted or unsubstituted aryl group of 6 to 30 ring-forming carbon atoms, or a substituted or unsubstituted heteroaryl group of 2 to 30 ring-forming carbon atoms. In some embodiments, in Formula H-1, $Ar_3$ may be a substituted or unsubstituted aryl group of 6 to 30 ring-forming carbon atoms, or a substituted or unsubstituted heteroaryl group of 2 to 30 ring-forming carbon atoms.

The compound represented by Formula H-1 may be a monoamine compound. In some embodiments, the compound represented by Formula H-1 may be a diamine compound in which at least one selected from among $Ar_1$ to $Ar_3$ may include an amine group as a substituent. In some embodiments, the compound represented by Formula H-1 may be a carbazole-based compound in which at least one selected from among $Ar_1$ and $Ar_2$ may include a substituted or unsubstituted carbazole group, or a fluorene-based compound in which at least one selected from among $Ar_1$ and $Ar_2$ may include a substituted or unsubstituted fluorene group.

The compound represented by Formula H-1 may be represented by any one selected from among the compounds in Compound Group H. However, the compounds shown in Compound Group H are only illustrations, and the compound represented by Formula H-1 is not limited to the compounds represented in Compound Group H.

## Compound Group H

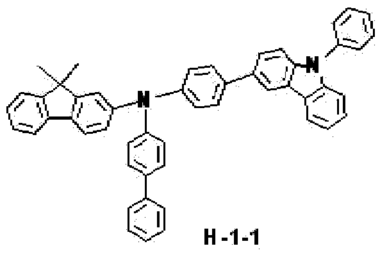
H-1-1

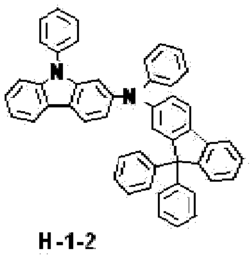
H-1-2

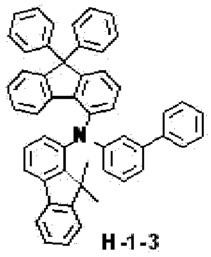
H-1-3

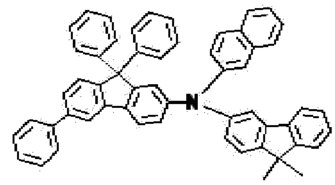
H-1-4

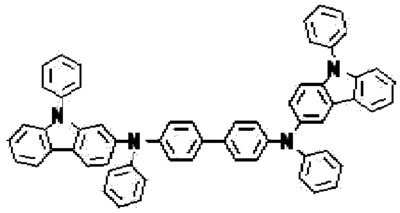
H-1-5

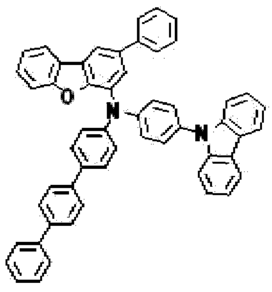
H-1-6

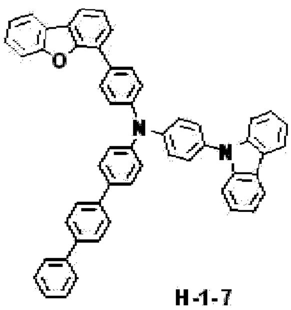
H-1-7

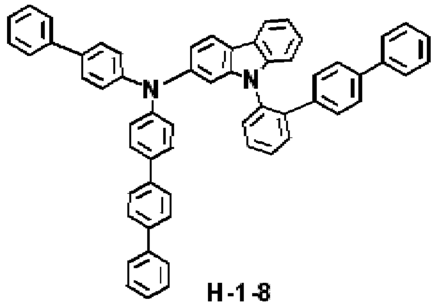
H-1-8

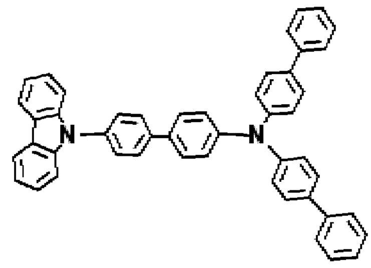
H-1-9

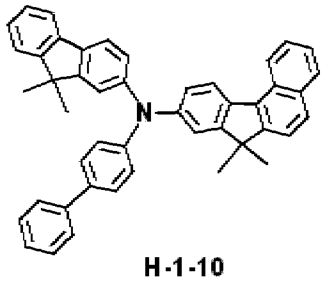
H-1-10

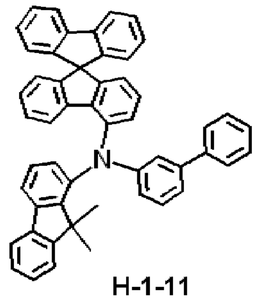
H-1-11

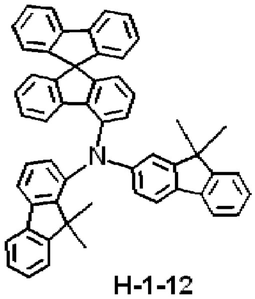
H-1-12

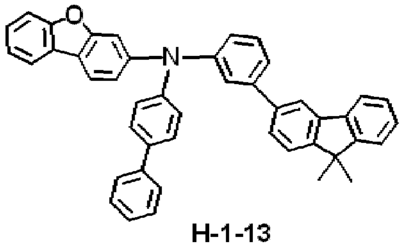
H-1-13

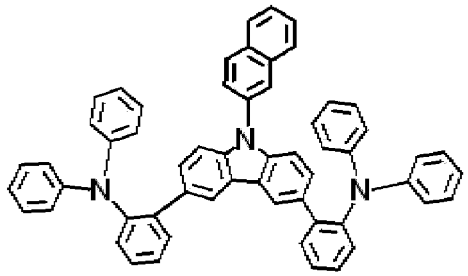
H-1-14

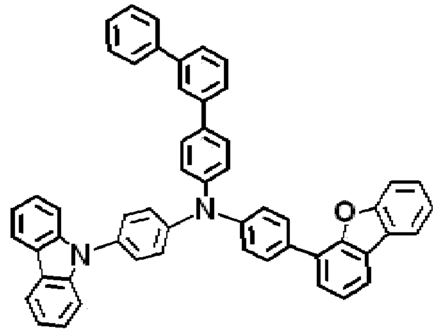
H-1-15

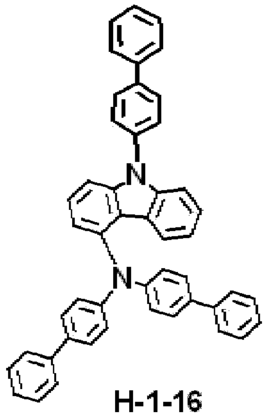
H-1-16

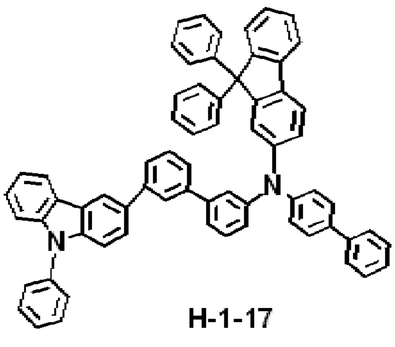
H-1-17
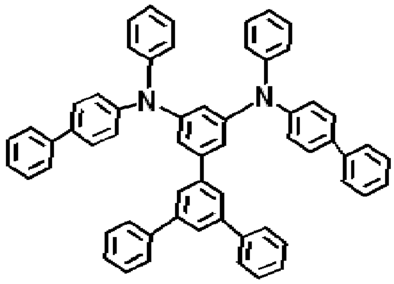
H-1-18
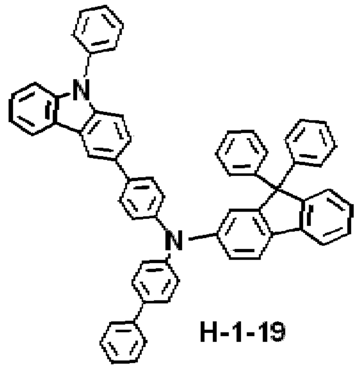
H-1-19
.

The hole transport region HTR may include a phthalocyanine compound such as copper phthalocyanine, $N^1$,$N^{1'}$-([1,1'-biphenyl]-4,4'-diyl)bis($N^1$-phenyl-$N^4$,$N^4$-dim-tolylbenzene-1,4-diamine) (DNTPD), 4,4',4"-[tris(3-methylphenyl)phenylamino] triphenylamine (m-MTDATA), 4,4',4"-tris(N,N-diphenylamino)triphenylamine (TDATA), 4,4',4"-tris[N-(1-naphthyl)-N-phenylamino]-triphenylamine (1-TNA TA), 4,4',4"-tris[N(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), N,N'-di(1-naphthalene-1-yl)-N,N'-diphenyl-benzidine (NPB) (or NPD), triphenylamine-containing polyetherketone (TPAPEK), 4-isopropyl-4'-methyldiphenyliodonium [tetrakis(pentafluorophenyl)borate], and/or dipyrazino[2,3-f:2',3'-h] quinoxaline-2,3,6,7,10,11 -hexacarbonitrile (HATCN).

The hole transport region HTR may include carbazole derivatives such as N-phenylcarbazole and polyvinylcarbazole, fluorene-based derivatives, triphenylamine-based derivatives such as 4,4',4"-tris(N-carbazolyl)triphenylamine (TCTA), N,N'-bis(3-methylphenyl)-N,N'-diphenyl-[1,1'-biphenyl]-4,4'-diamine (TPD), N,N'-di(naphthalene-1-yl)-N,N'-diphenyl-benzidine (NPB), 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 1,3-bis(N-carbazolyl)benzene (mCP), and/or the like.

In some embodiments, the hole transport region HTR may include 9-(4-tert-butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol-9-yl)benzene (mDCP), etc.

The hole transport region HTR may include the compounds of the hole transport region in at least one selected from among the hole injection layer HIL, hole transport layer HTL, and other auxiliary layers included in the hole transport region HTR.

The hole transport region HTR may further include a charge generating material to increase conductivity in addition to the above-described materials. The charge generating material may be dispersed uniformly or non-uniformly in the hole transport region HTR. The charge generating material may be, for example, a p-dopant. The p-dopant may include at least one selected from among metal halide compounds, quinone derivatives, metal oxides, and cyano group-containing compounds, without limitation. For example, the p-dopant may include metal halide compounds such as CuI and RbI, quinone derivatives such as tetracyanoquinodimethane (TCNQ) and 2,3,5,6-tetrafluoro-7,7',8,8-tetracyanoquinodimethane (F4-TCNQ), metal oxides such as tungsten oxide and molybdenum oxide, cyano group-containing compounds such as dipyrazino[2,3-f: 2',3'-h] quinoxaline-2,3,6,7,10,11-hexacarbonitrile (HATCN) and 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), etc., without limitation.

In one or more embodiments, in the light emitting diode ED, the HOMO energy level of the hole transport region HTR may be about -4.71 eV, and the lowest unoccupied molecular orbital (LUMO) energy level thereof may be about -0.88 eV. In some embodiments, when the hole transport region HTR may include a p-dopant, the HOMO energy level of the p-dopant may be about -7.5 eV, and the LUMO energy level of the p-dopant may be about -5.34 eV. However, embodiments of the present disclosure are not limited thereto, and the HOMO energy level and the LUMO energy level utilized in the hole transport region HTR may be changed according to the type or kind of a material utilized in a range having a HOMO energy level that may easily transfer holes to the emission structure EML.

In one or more embodiments, in the light emitting diode ED, the emission structure EML may include an emission layer EM disposed on the hole transport region HTR.

The emission layer EM may have a single layer formed utilizing a single material, a single layer formed utilizing a plurality of different materials, or a multilayer structure having a plurality of layers formed utilizing a plurality of different materials.

In one or more embodiments, the emission layer EM may include a hole transport host, an electron transport host, and a dopant. In one or more embodiments, in the light emitting diode ED, the dipole moment of the dopant may be about 2.0 Debye (D) or less. For example, in some embodiments, the dipole moment of the dopant included in the emission layer EM may be about 1.80 D or less. In some embodiments, the emission layer EM of the light emitting diode

ED may be to emit green light, and the emission layer EM emitting green light may include a dopant having a dipole moment of about 2.0 D or less.

In some embodiments, the dipole moment of the dopant in the present disclosure is a value calculated utilizing a density functional theory (DFT), and a Gaussian 09 program was utilized for calculating the dipole moment.

In one or more embodiments, the light emitting diode ED may include a dopant material having a small dipole moment (e.g., about 2.0 D or less) in the emission layer EM, and the bending of the energy band in the light emitting diode ED according to the polarity of the emission layer EM may be suppressed or reduced. As a result, hole accumulation in the emission auxiliary layer A-EM, etc., may not increase, and the increase of capacitance in the light emitting diode ED may be prevented or reduced.

In FIG. 5, the maximum capacitance (Max. capacitance) in the light emitting diodes utilizing the dopant materials of an Example and Comparative Examples is compared and shown. Referring to FIG. 5, it could be found that the maximum capacitance in the light emitting diode decreases when a dipole moment value decreases. For example, it could be found that in the light emitting diodes of Comparative Example 1 and Comparative Example 2, utilizing dopant materials having dipole moment values greater than about 2.0 D, higher capacitance was shown when compared to the Example utilizing a dopant material having a dipole moment of about 1.4 D.

Accordingly, in some embodiments, the light emitting diode ED may include a dopant material having a dipole moment of about 2.0 D or less in the emission layer EM, and may reduce the accumulation phenomenon of holes in the emission layer EM even driving for a long time, thereby preventing or reducing the deterioration of light emitting properties. In one or more embodiments, the light emitting diode ED may include a dopant material having a small dipole moment of about 2.0 D or less, initial capacitance may be reduced, capacitance after driving for a long time and the change of initial capacitance may be reduced, and inverse current burn-in may be improved. For example, in some embodiments, in the light emitting diode emitting green light among the light emitting diodes ED, a dopant having a small dipole moment (e.g., about 2.0 D or less) may be included, capacitance decrease before and after driving for a long time may be reduced, and defects of deteriorating light emitting properties including inverse current burn-in may be markedly ameliorated.

In one or more embodiments, the dopant included in the emission layer EM may be an organometallic complex including Pt as a central metal atom.

For example, in one or more embodiments, the emission layer EM may include a material represented by Formula M as a dopant. However, embodiments of the present disclosure are not limited thereto, and the emission layer EM may include any dopant materials satisfying the above-described range of the dipole moment value, without limitation.

**Formula M**

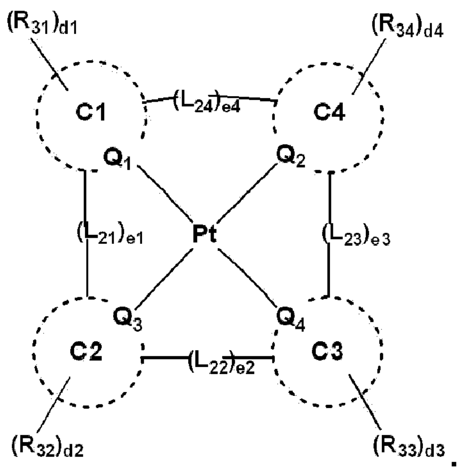

In Formula M, $Q_1$ to $Q_4$ may each independently be C or N, and C1 to C4 may each independently be a substituted or unsubstituted hydrocarbon ring of 5 to 30 ring-forming carbon atoms, or a substituted or unsubstituted heterocycle of 2 to 30 ring-forming carbon atoms.

$L_{21}$ to $L_{24}$ may each independently be selected from among a direct linkage, *-o-*, *-s-*, > >

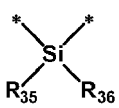 , 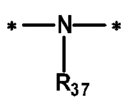 , 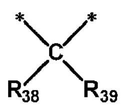 , 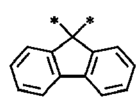 ,

a substituted or unsubstituted divalent alkyl group of 1 to 20 carbon atoms, a substituted or unsubstituted arylene group of 6 to 30 ring-forming carbon atoms, and a substituted or unsubstituted heteroarylene group of 2 to 30 ring-forming carbon atoms, and e1 to e4 may each independently be 0 or 1. $R_{31}$ to $R_{39}$ may each independently be selected from among hydrogen, deuterium, a halogen, a cyano group, a substituted or unsubstituted amine group, a substituted or unsubstituted alkyl group of 1 to 20 carbon atoms, a substituted or unsubstituted aryl group of 6 to 30 ring-forming carbon atoms, and a substituted or unsubstituted heteroaryl group of 2 to 30 ring-forming carbon atoms, or may be combined with an adjacent group to form a ring. d1 to d4 may each independently be an integer of 0 or 4.

The compound represented by Formula M may be utilized as a green phosphorescence dopant. However, embodiments of the present disclosure are not limited thereto.

The compound represented by Formula M may be represented by any one selected from among the compounds below. However, the compounds are illustrations, and the compound represented by Formula M is not limited to the compounds represented below.

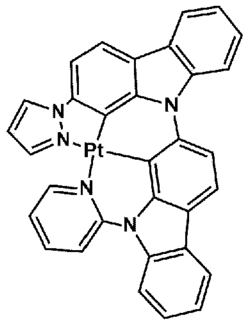

M-b-1

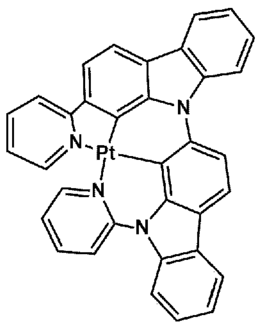

M-b-2

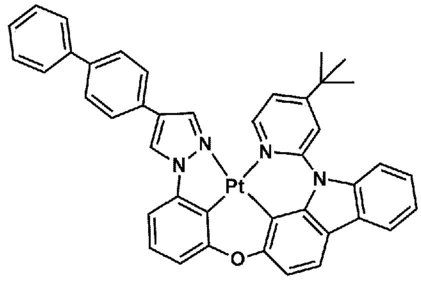

M-b-3

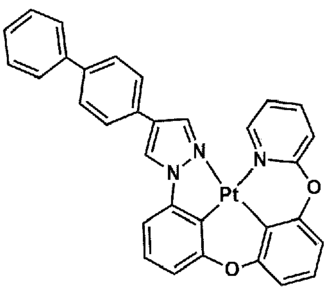

M-b-4

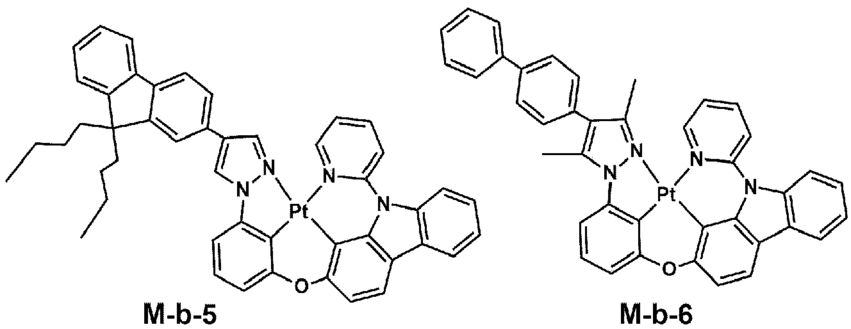

M-b-5

M-b-6

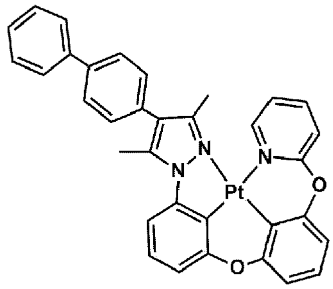

M-b-7

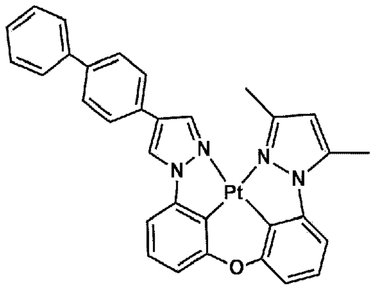

M-b-8

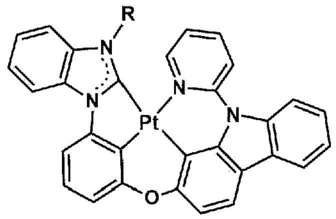

M-b-9

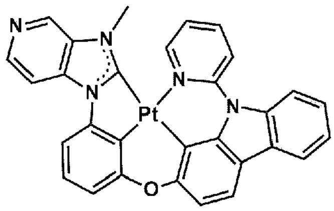

M-b-10

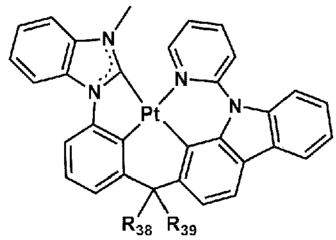

M-b-11

.

In Compounds M-b-1 to M-b-11, R, $R_{38}$, and $R_{39}$ may each independently be a hydrogen atom, a deuterium atom, a halogen atom, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

The emission layer EM may include a hole transport host and an electron transport host. For example, in one or more embodiments, the HOMO energy level of the hole transport host may be about -4.97 eV, and the LUMO energy level of the electron transport host may be about -1.94 eV. However, embodiments of the present disclosure are not limited thereto.

In some embodiments, in the emission layer EM, an exciplex may be formed by the hole transport host and the electron transport host. The triple energy of the exciplex formed by the hole transport host and the electron transport host may correspond to the gap between the LUMO energy level of the electron transport host and the HOMO energy level of the hole transport host.

In one or more embodiments, the emission layer EM may include a compound represented by Formula HTH-1 as the hole transport host.

**Formula HTH-1**

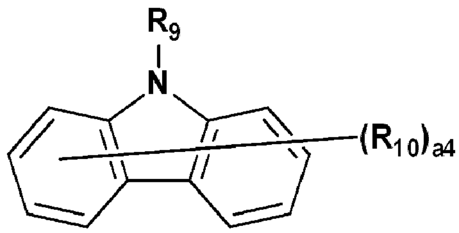

.

In Formula HTH-1, a4 may be an integer of 0 to 8. When a4 is an integer of 2 or more, a plurality of $R_{10}$s may be the same, or at least one may be different. $R_9$ and $R_{10}$ may each independently be selected from among hydrogen, deuterium, a substituted or unsubstituted aryl group of 6 to 60 ring-forming carbon atoms, and a substituted or unsubstituted heteroaryl group of 2 to 60 ring-forming carbon atoms. For example, in some embodiments, $R_9$ may be a substituted phenyl group, an unsubstituted dibenzofuran group, or a substituted fluorenyl group. $R_{10}$ may be a substituted or unsubstituted carbazole group.

The hole transport host may include at least one selected from among the compounds in Compound Group HT. However, the compounds shown in Compound Group HT are illustrations of the hole transport host, and the type or kind of the hole transport host included in the emission layer EM of one or more embodiments is not limited thereto. In some embodiments, in Compound Group HT, "D" is deuterium.

## Compound Group HT

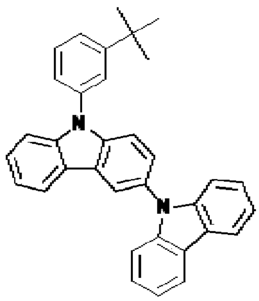

HT1

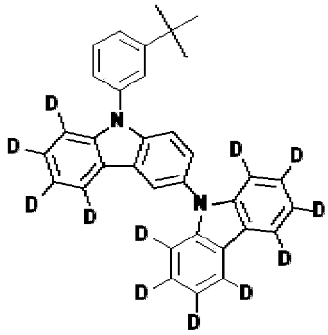

HT2

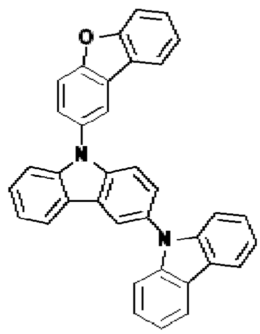

HT3

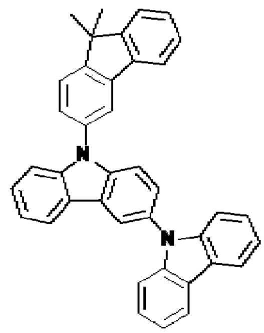

HT4

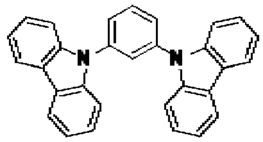

HT5

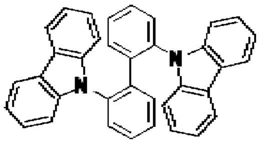

HT6

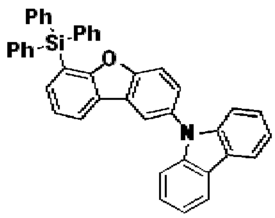

HT7

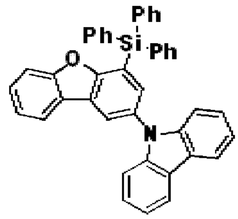

HT8

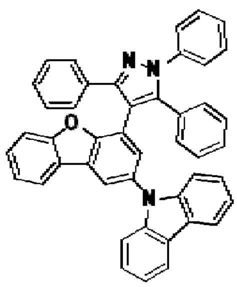

HT9

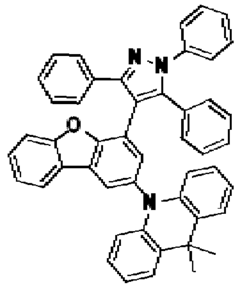

HT10

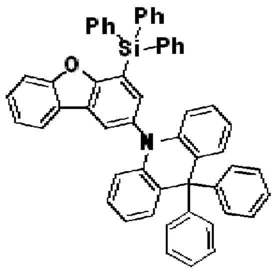

HT11

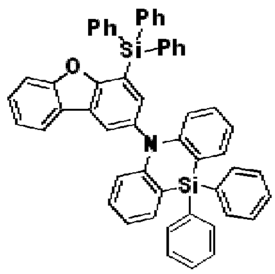

HT12

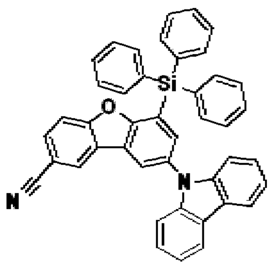

HT13

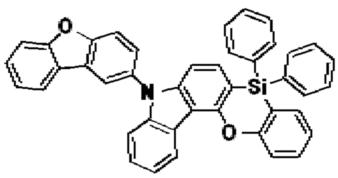

HT14

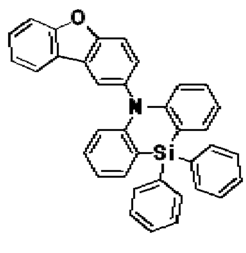

HT15

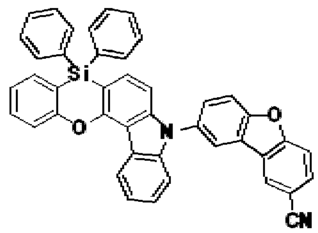

HT16

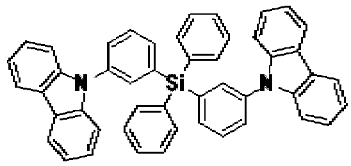
**HT17**

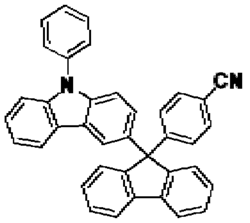
**HT18**

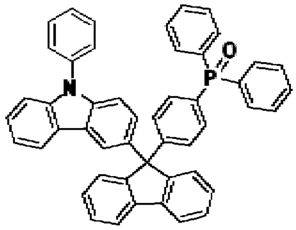
**HT19**

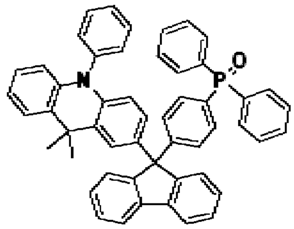
**HT20**

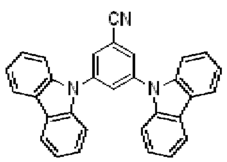
HT21

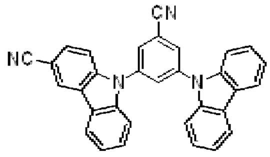
HT22

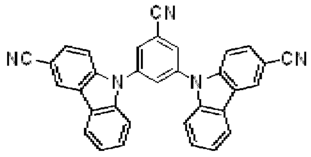
HT23

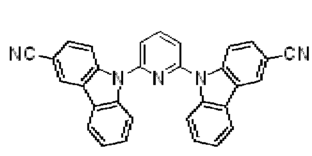
HT24

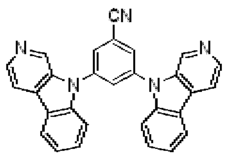
HT25

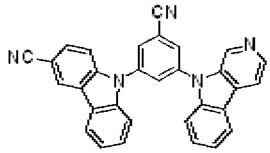
HT26

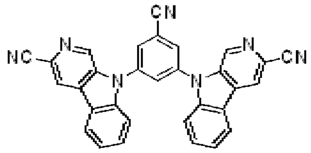
HT27

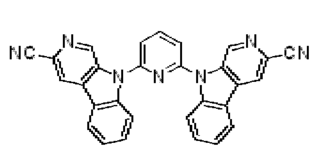
HT28

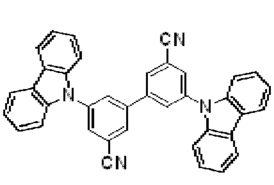
HT29

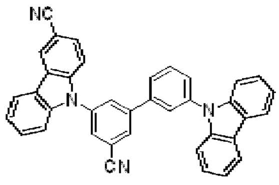
HT30

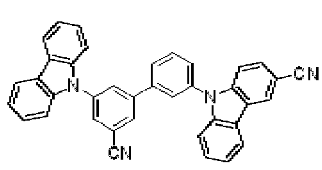
HT31

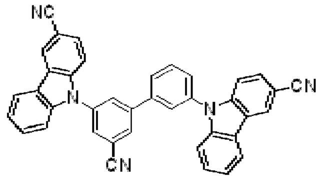
HT32

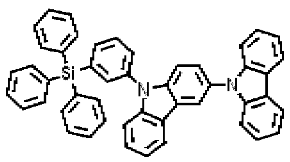
HT33

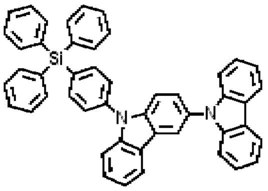
HT34

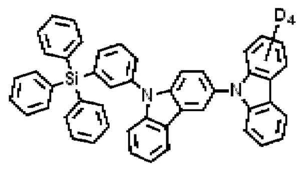
HT35

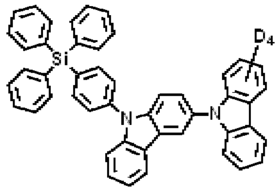
HT36

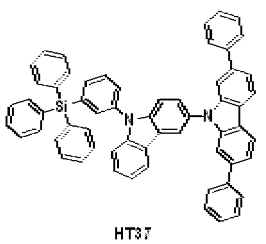
HT37

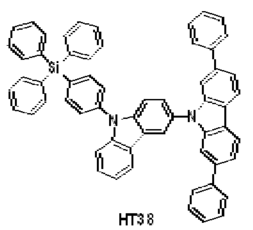
HT38

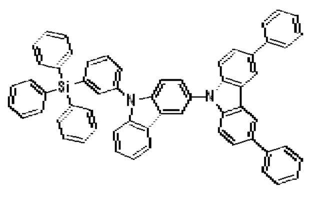
HT39

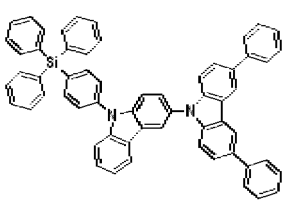
HT40

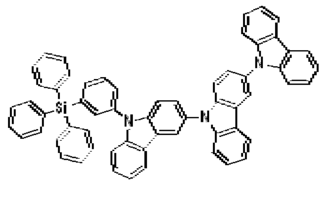

HT41

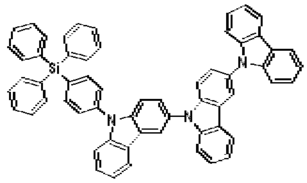

HT42

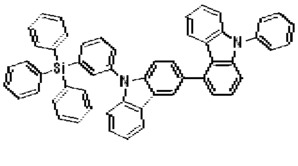

HT43

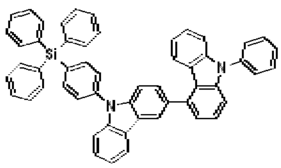

HT44

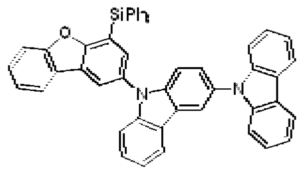

HT45

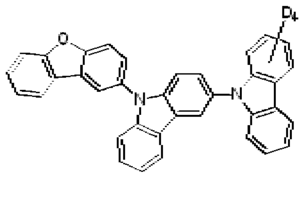

HT46

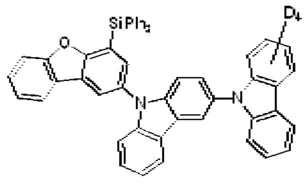

HT47

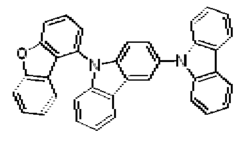

HT48

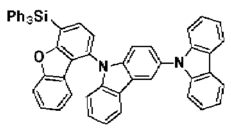

HT49

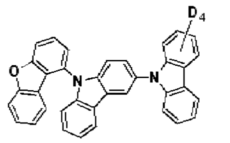

HT50

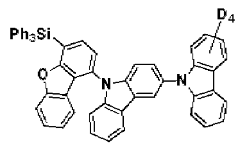

HT51

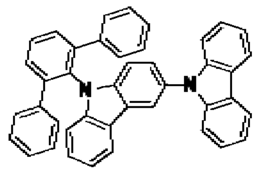

HT52

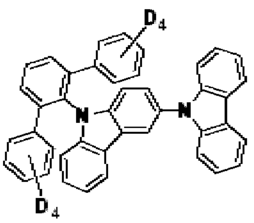

HT53

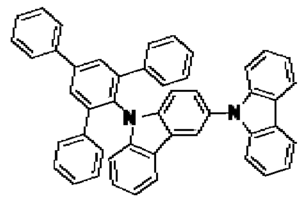

HT54

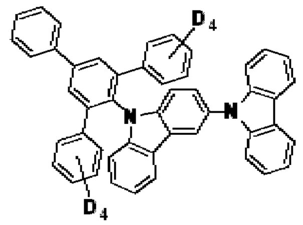

HT55

.

In one or more embodiments, the emission layer EM may include a compound represented by Formula ETH-1 as the electron transport host.

## Formula ETH-1

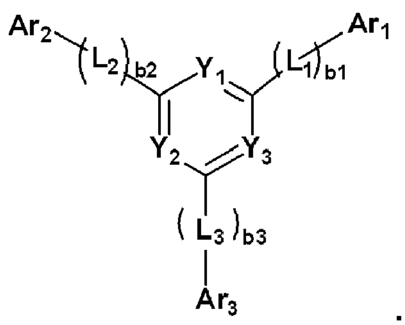

.

In Formula ETH-1, at least one selected from among $Y_1$ to $Y_3$ may be N, and the remainder may be $CR_a$, and $R_a$ may be selected from among hydrogen, deuterium, a substituted or unsubstituted alkyl group of 1 to 20 carbon atoms, a substituted or unsubstituted aryl group of 6 to 60 ring-forming carbon atoms, and a substituted or unsubstituted heteroaryl group of 2 to 60 ring-forming carbon atoms.

b1 to b3 may each independently be an integer of 0 to 10. $L_1$ to $L_3$ may each independently be selected from among a direct linkage, a substituted or unsubstituted arylene group of 6 to 30 ring-forming carbon atoms, and a substituted or unsubstituted heteroarylene group of 2 to 30 ring-forming carbon atoms.

$Ar_1$ to $Ar_3$ may each independently be selected from among hydrogen, deuterium, a substituted or unsubstituted

alkyl group of 1 to 20 carbon atoms, a substituted or unsubstituted aryl group of 6 to 30 ring-forming carbon atoms, and a substituted or unsubstituted heteroaryl group of 2 to 30 ring-forming carbon atoms. For example, in some embodiments, $Ar_1$ to $Ar_3$ may be selected from among substituted or unsubstituted phenyl groups and substituted or unsubstituted carbazole groups.

The electron transport host may include or be represented by any one selected from among the compounds in Compound Group ET. However, the compounds shown in Compound Group ET are illustrations, and the type or kind of the electron transport host included in the emission layer EM of one or more embodiments is not limited thereto. In some embodiments, in Compound Group ET, "D" is deuterium.

## Compound Group ET

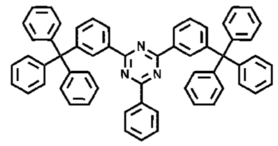
ETH1

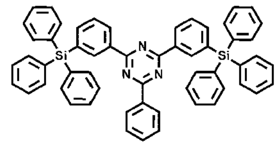
ETH2

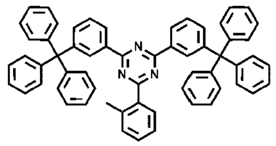
ETH3

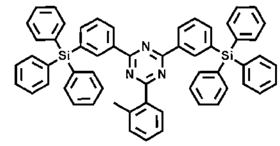
ETH4

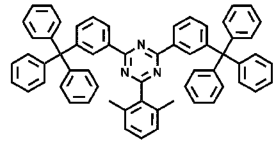
ETH5

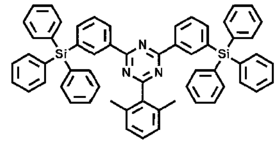
ETH6

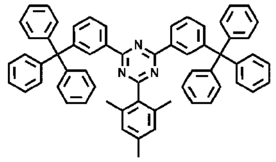
ETH7

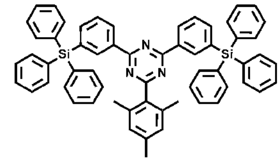
ETH8

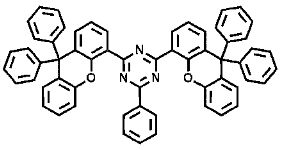
ETH9

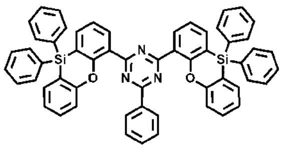
ETH10

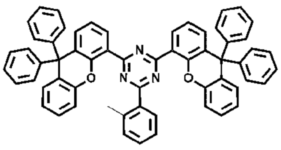
ETH11

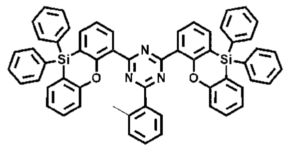
ETH12

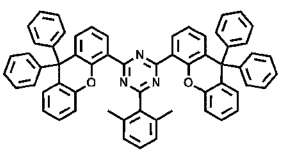
ETH13

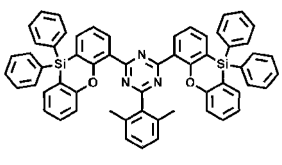
ETH14

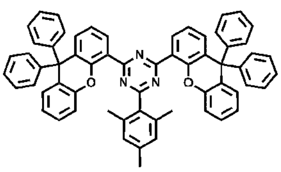
ETH15

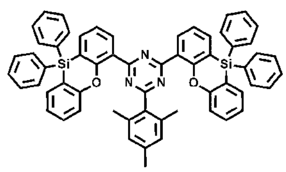
ETH16

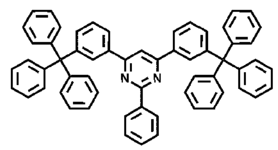
ETH17

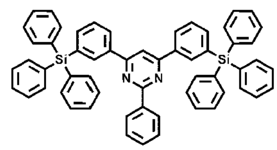
ETH18

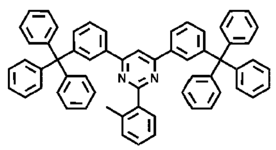
ETH19

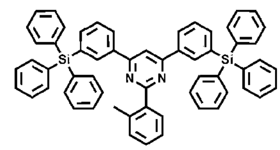
ETH20

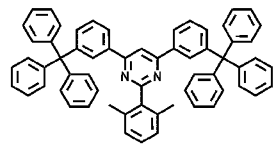
ETH21

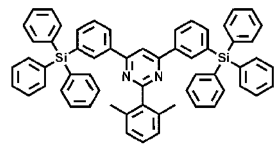
ETH22

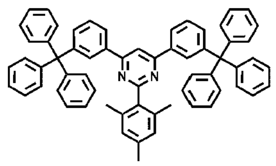
ETH23

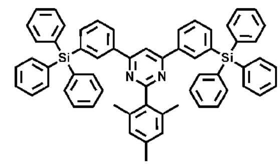
ETH24

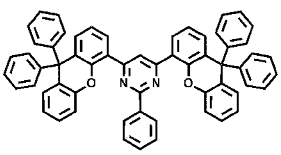
ETH25

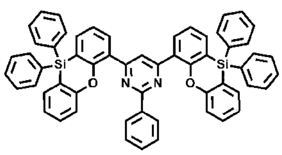
ETH26

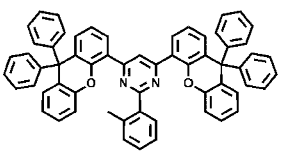
ETH27

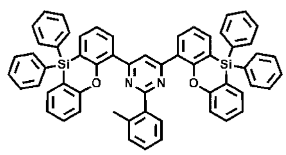
ETH28

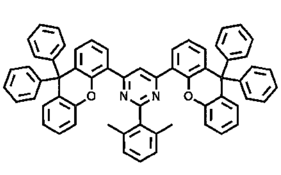
ETH29

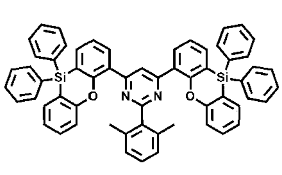
ETH30

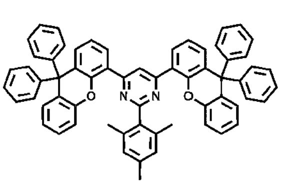
ETH31

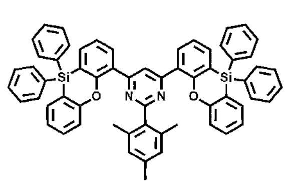
ETH32

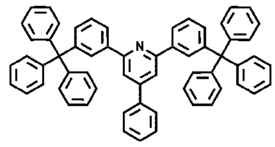
ETH33

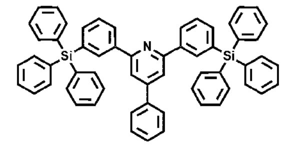
ETH34

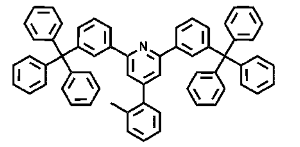
ETH35

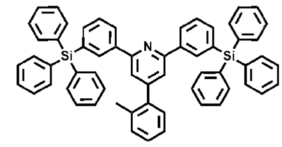
ETH36

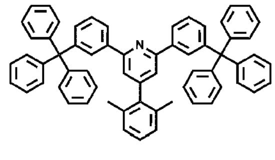
ETH37

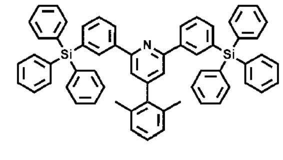
ETH38

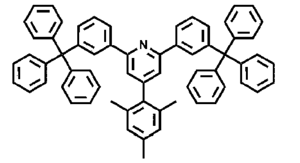
ETH39

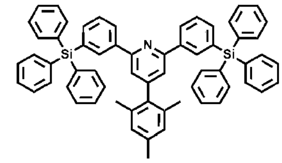
ETH40

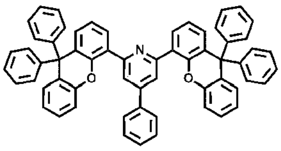
ETH41

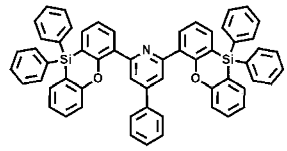
ETH42

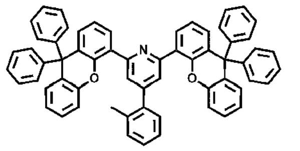
ETH43

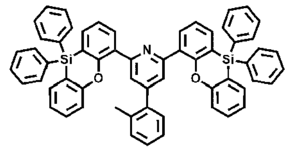
ETH44

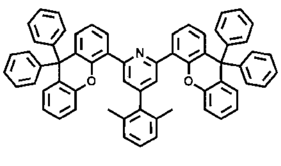
ETH45

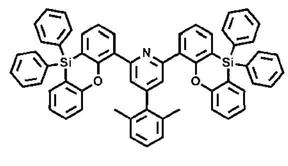
ETH46

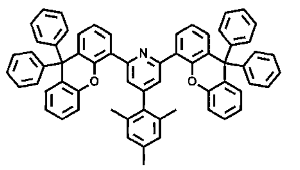
ETH47

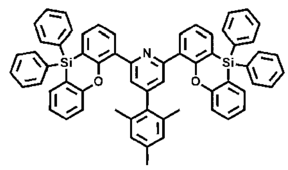
ETH48

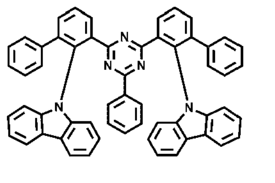
ETH49

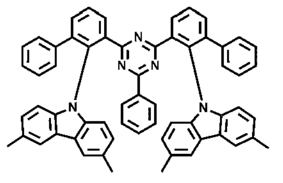
ETH50

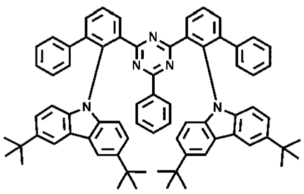
ETH51

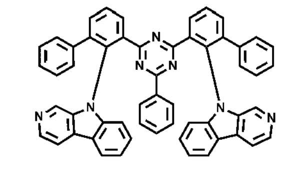
ETH52

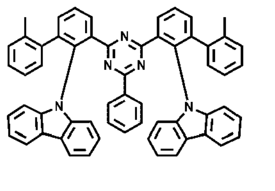
ETH53

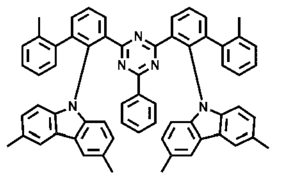
ETH54

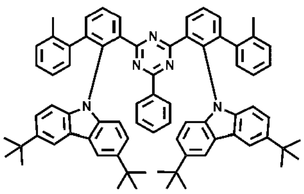
ETH55

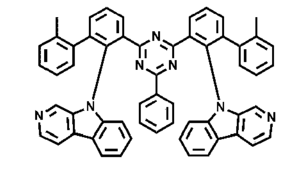
ETH56

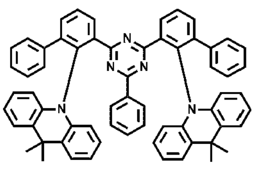
ETH57

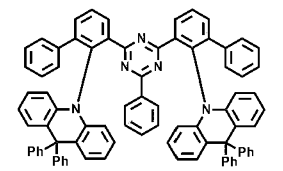
ETH58

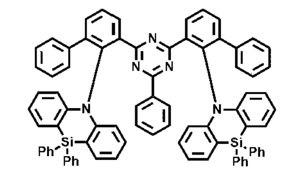
ETH59

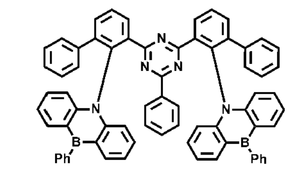
ETH60

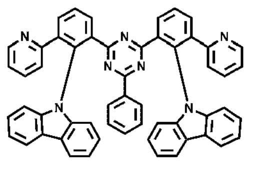
ETH61

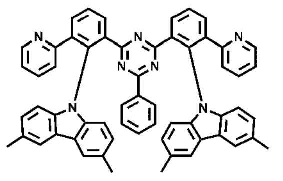
ETH62

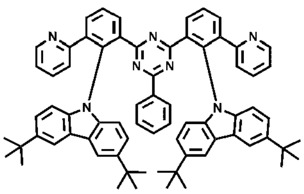
ETH63

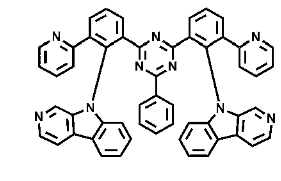
ETH64

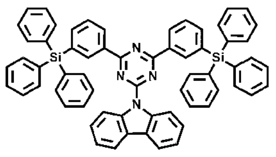
ETH65

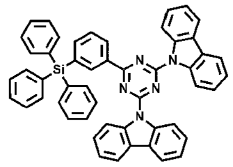
ETH66

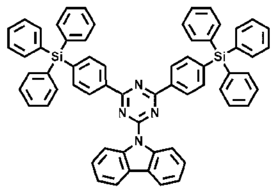
ETH67

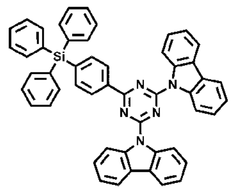
ETH68

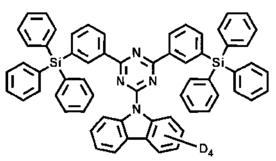
ETH69

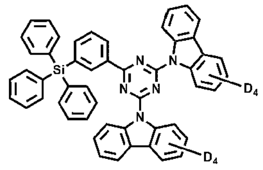
ETH70

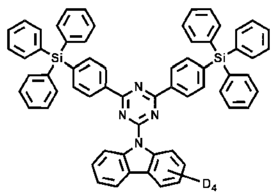
ETH71

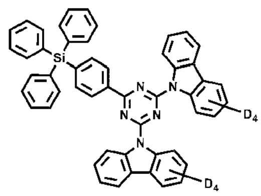
ETH72

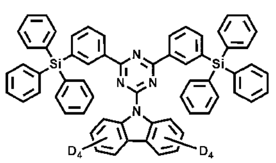
ETH73

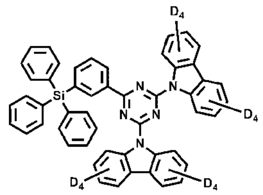
ETH74

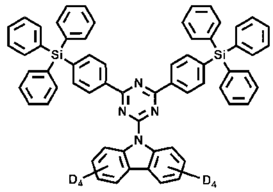
ETH75

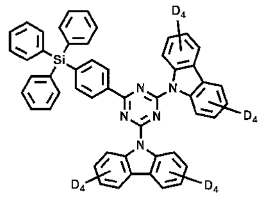
ETH76

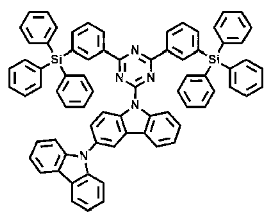
ETH77

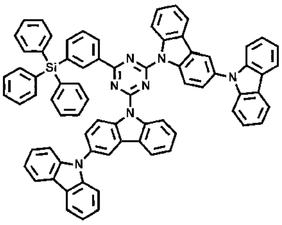
ETH78

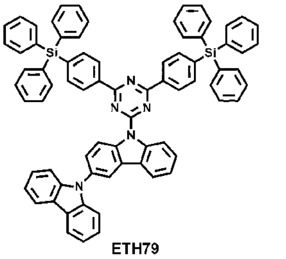
ETH79

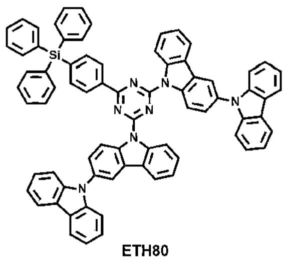
ETH80

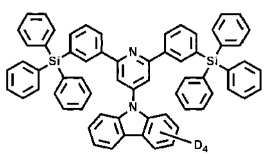
ETH81

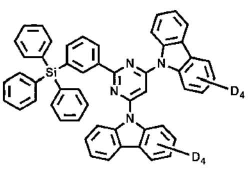
ETH82

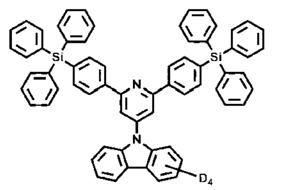
ETH83

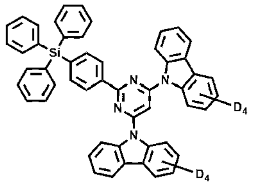
ETH84

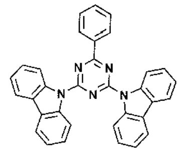
ETH85

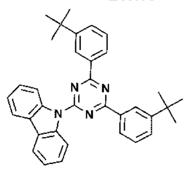
ETH86 .

In some embodiments, the emission layer EM- may further include a common material well-suitable in the art as a host material. For example, the emission layer EM may include, as the host material, at least one selected from among bis (4-(9H-carbazol-9-yl) phenyl) diphenylsilane (BCPDS), (4-(1-(4-(diphenylamino) phenyl) cyclohexyl) phenyl) diphenyl-phosphine oxide (POPCPA), bis[2-(diphenylphosphino)phenyl] ether oxide (DPEPO), 4,4'-bis(N-carbazolyl)-1,1'-biphenyl (CBP), 1,3-bis(carbazol-9-yl)benzene (mCP), 2,8-bis(diphenylphosphoryl)dibenzo[b,d]furan (PPF), 4,4',4"-tris(carbazol-9-yl)-triphenylamine (TCTA), and 1,3,5-tris(1-phenyl-1H-benzo[d]imidazole-2-yl)benzene (TPBi). However, embodiments of the present disclosure are not limited thereto. For example, in some embodiments, tris(8-hydroxyquinolino)aluminum ($Alq_3$), 9,10-di(naphthalene-2-yl)anthracene (ADN), 2-tert-butyl-9,10-di(naphth-2-yl)anthracene (TBADN), distyrylarylene (DSA), 4,4'-bis(9-carbazolyl)-2,2'-dimethyl-biphenyl (CDBP), 2-methyl-9,10-bis(naphthalen-2-yl)anthracene (MADN), hexaphenyl cyclotriphosphazene (CP1), 1,4-bis(triphenylsilyl)benzene (UGH2), hexaphenylcyclotrisiloxane (DPSiOs), octaphenylcyclotetra siloxane ($DPSiO_4$), etc. may be utilized as the host material.

In some embodiments, the emission layer EM may further include a suitable dopant material in addition to the above-described dopant materials. In some embodiments, the first light emitting diode ED-R and the third light emitting diode ED-B among the light emitting diodes ED-R, ED-G, and ED-B of the display diode layer explained in FIG. 3A, etc., may include a dopant material other than the dopant material having the dipole moment of about 2.0 D or less. The dopant material may utilize a phosphorescence dopant material, a fluorescence dopant material, and/or a thermally activated delayed fluorescence dopant material.

In some embodiments, the emission layer EM may further include an auxiliary dopant in addition to the hole transport host, the electron transport host, and the dopant. The auxiliary dopant may transfer the energy of the host to the dopant. For example, in one or more embodiments, a phosphorescence dopant material or a thermally activated delayed fluorescence dopant material may be included as the auxiliary dopant.

In one or more embodiments, the light emitting diode ED may include an emission auxiliary layer A-EM in the emission structure EML. In the emission structure EML, the emission auxiliary layer A-EM may be a layer disposed adjacent to the hole transport region HTR.

The emission auxiliary layer A-EM may facilitate the transfer of the holes to the emission layer EM. In some embodiments, the emission auxiliary layer A-EM may compensate the resonance distance according to the wavelength of light emitted from the emission layer EM to increase light emitting efficiency in the light emitting diode ED. The emission auxiliary layer A-EM may include at least one selected from among the above-described materials utilized in the hole transport region HTR. In some embodiments, the HOMO energy level of the emission auxiliary layer A-EM may be lower than the HOMO energy level of the hole transport region HTR. For example, in one or more embodiments, in the light emitting diode ED, the HOMO energy level of the emission auxiliary layer A-EM may be about -4.79 eV. However, embodiments of the present disclosure are not limited thereto.

In one or more embodiments, the light emitting diode ED may include a first buffer layer BFL1 in the emission structure EML. The first buffer layer BFL1 may be disposed between the emission auxiliary layer A-EM and the emission layer EM. In some embodiments, the first buffer layer BFL1 may be disposed directly between the emission auxiliary layer A-EM and the emission layer EM.

In one or more embodiments, the HOMO energy level of the first buffer layer BFL1 may be lower than the HOMO energy level of the emission auxiliary layer A-EM. In some embodiments, the HOMO energy level of the first buffer layer BFL1 may be substantially equal to or higher than the HOMO energy level of the hole transport host.

FIG. 6A illustrates an energy diagram in a part of the light emitting diode according to an embodiment of the present disclosure. FIG. 6B illustrates an energy diagram in a part of the light emitting diode according to a comparative embodiment. In FIG. 6A and FIG. 6B, the energy levels of emission auxiliary layers A-EM, first buffer layers BFL1 and BFL1', hole transport hosts HT, and electron transport hosts ET in the light emitting diodes are illustrated.

Referring to FIG. 6A, the HOMO energy level HV-1 of the first buffer layer BFL1 may be lower than the HOMO energy level HV-2 of the emission auxiliary layer A-EM and may be substantially equal to or higher than the HOMO energy level HV-3 of the hole transport host HT. In some embodiments, the gap between the HOMO energy level HV-1 of the first buffer layer BFL1 and the HOMO energy level HV-2 of the emission auxiliary layer A-EM may be greater than the gap between the HOMO energy level HV-1 of the first buffer layer BFL1 and the HOMO energy level HV-3 of the hole transport host. In one or more embodiments, the HOMO energy level HV-1 of the first buffer layer BFL1 may be about -4.96 eV, the HOMO energy level HV-2 of the emission auxiliary layer A-EM may be about -4.79 eV, and the HOMO energy level HV-3 of the hole transport host may be about -4.97 eV. However, embodiments of the present disclosure are not limited thereto. In one or more embodiments, the first buffer layer BFL1 may include materials having an HOMO energy level HV-1 lower than the HOMO energy level HV-2 of the emission auxiliary layer A-EM and substantially equal to or higher than the HOMO energy level HV-3 of the hole transport host, and satisfying the range conditions of a greater gap from the HOMO energy level HV-2 of the emission auxiliary layer A-EM than the gap from the HOMO energy level HV-3 of the hole transport host, without limitation.

In the case of the light emitting diode ED' of a comparative embodiment, as shown in FIG. 6B, there is a difference in the energy level of the first buffer layer BFL1 ' when compared to the light emitting diode ED of an embodiment of the present disclosure, as shown in FIG. 6A. In the light emitting diode ED' of the comparative embodiment, the HOMO energy level HV-1' of the first buffer layer BFL1' may be a value greater than the HOMO energy level HV-2 of the emission auxiliary layer A-EM and the HOMO energy level HV-3 of the hole transport host. However, when compared to the light emitting diode ED of an embodiment of the present disclosure, shown in FIG. 6A, there is a difference in that the HOMO energy level HV-1' of the first buffer layer BFL1' is close to the HOMO energy level HV-2 of the emission auxiliary layer A-EM. For example, when compared to the gap between the HOMO energy level HV-1 of the first buffer layer BFL1 and the HOMO energy level HV-2 of the emission auxiliary layer A-EM, the absolute value of the gap between the HOMO energy level HV-1' of the first buffer layer BFL1 ' and the HOMO energy level HV-2 of the emission auxiliary layer A-EM may be smaller. The HOMO energy level HV-1' of the first buffer layer BFL1' in the light emitting diode ED' of a comparative embodiment, shown in FIG. 6B may be about -4.78 eV.

FIG. 7 is a diagram showing charge density change of an Example of the present disclosure and a Comparative

Example. FIG. 8 is a diagram showing capacitance change in an Example of the present disclosure and a Comparative Example. In FIG. 7 and FIG. 8, the Example corresponds to evaluation results on an embodiment having the light emitting diode structure of one or more embodiments of the present disclosure, shown in FIG. 6A, and the Comparative Example corresponds to evaluation results on an embodiment having the light emitting diode structure of a comparative embodiment, shown in FIG. 6B.

The charge density in FIG. 7 represents the density of holes, and referring to FIG. 7, in the Example, the charge density had the maximum value in the first buffer layer BFL1 and then the charge density decreased in the emission layer EM. In contrast, in the Comparative Example, the charge density showed the maximum value in the emission layer EM. For example, it could be confirmed that the Example including the first buffer layer BFL1 having a lower HOMO energy level showed reduced hole accumulation phenomenon in the emission layer EM when compared to the Comparative Example.

FIG. 8 shows the change of a capacitance value according to voltage. Referring to FIG. 8, it could be found that the maximum capacitance of the Example decreased in contrast to the Comparative Example. For example, it could be confirmed that the Example including the first buffer layer BFL1 having a lower HOMO energy level showed reduced capacitance in contrast to the Comparative Example.

Referring to FIG. 6A and FIG. 8, the light emitting diode ED according to one or more embodiments may include the first buffer layer BFL1 having the HOMO energy level HV-1 lower than the HOMO energy level HV-2 of the emission auxiliary layer A-EM and substantially equal to or higher than the HOMO energy level HV-3 of the hole transport host, and satisfying the range conditions of a greater gap from the HOMO energy level HV-2 of the emission auxiliary layer A-EM than the gap from the HOMO energy level HV-3 of the hole transport host, thereby reducing hole accumulation phenomenon in the emission layer EM and reducing the capacitance of the light emitting diode ED. For example, in one or more embodiments, the light emitting diode ED may include the first buffer layer BFL1 satisfying the above-described range of the HOMO energy level and disposed on the lower side of the emission layer EM, and may show improved properties of light emitting quality deterioration due to hole accumulation during re-operation after driving for a long time of the light emitting diode, and excellent or suitable emission properties.

FIG. 9 and FIG. 10 are diagrams showing display quality results in each display device state. FIG. 9 is a diagram showing the amount of capacitance change and the evaluation results of display quality in the Examples and Comparative Example, and FIG. 10 is a diagram showing the initial value of capacitance and the evaluation results of display quality in the Examples and Comparative Example.

The display devices utilized for the evaluation of display quality of FIG. 9 and FIG. 10 may include a display diode layer DP-ED (FIG. 2) including first to third light emitting diodes ED-R, ED-G, and ED-B (FIG. 2). In FIG. 9 and FIG. 10, the second light emitting diode ED-G included in the display devices utilized in Comparative Example 1 and Examples 1 and 2 may have the structure of the light emitting diode ED shown in FIG. 4.

In some embodiments, in FIG. 9 and FIG. 10, the Comparative Example may include an organometallic complex including Ir as a central metal, as the dopant material of the emission layer EM, and the dipole moment of the dopant utilized in the Comparative Example was about 6.81 D. The dopant material of the emission layer EM in Example 1 and Example 2 utilized an organometallic complex including Pt as a central metal, and the dipole moment of the dopant material of the emission layer utilized in Example 1 and Example 2 was about 1.76 D. Meanwhile, different from Example 1, in Example 2, the HOMO energy level of the first buffer layer BFL1 is lower than the HOMO energy level of the emission auxiliary layer A-EM and is substantially equal to or higher than the HOMO energy level of the hole transport host, and the range conditions are satisfied in that the gap from the HOMO energy level of the emission auxiliary layer A-EM is greater than the gap from the HOMO energy level of the hole transport host. For example, this corresponds to a case where the HOMO energy level of the first buffer layer BFL1 in Example 2 is lower than the HOMO energy level of the first buffer layer BFL1 in Example 1.

In addition, in FIG. 9 and FIG. 10, the evaluation of display quality is shown by luminance ratio (%). The luminance ratio (%) shown in FIG. 9 and FIG. 10 is represented by percent of the ratio of luminance (first area/second area) after driving a first area and a second area by white and black, respectively, for a long time and then re-operating the first area and the second area. For example, the luminance ratio (%) of 100% corresponds to an ideal value. In some embodiments, when the luminance ratio (%) approaches 100%, it could be considered that the inverse current burn-in is improved at low gradation after driving for a long time, while dividing white and black.

In FIG. 9, "$\triangle C_{max}$(%)" is represented by a "$\triangle C_{max}$" value by percent represented by Equation 1. In Equation 1, "$C_{max}(T_0)$" is the maximum value of initial capacitance, and "$C_{max}(T_{95})$" corresponds to the maximum value of capacitance when diode lifetime reached about 95%.

## Equation 1

$$\triangle C_{max} = [1 - C_{max}(T_{95}) / C_{max}(T_0)]$$

.

In FIG. 10, "Initial cap." represents the capacitance value of a light emitting diode, and corresponds to the maximum value of capacitance in an initial light emitting diode before driving for a long time.

In a deteriorated state of the initial capacitance and lifetime, with the decrease of the capacitance, the luminance ratio may close further to about 100%, and referring to FIG. 9, it could be confirmed that the luminance ratios were reduced in Example 1 and Example 2 in comparison to the Comparative Example.

For example, it could be confirmed that by including a dopant material having a small dipole moment of about 2.0 D or less in an emission layer, and even though the lifetime decreases according to the utilization of the light emitting diodes for a long time, the luminance difference between a part driven white for a long time and a part driven black for a long time is reduced when compared to the Comparative Example, and excellent or suitable life-characteristics and diode operation properties may be shown. In some embodiments, when comparing Example 1 and Example 2, in Example 2 wherein utilized is a material having a small dipole moment (e.g., about 2.0 D or less) as the dopant, and included is a first buffer layer having a HOMO energy level lower than the HOMO energy level of an emission auxiliary layer and substantially equal to or higher than the HOMO energy level of a hole transport host, and having a lower HOMO energy level than a first buffer layer included in Example 1, improved luminance ratio properties are shown in contrast to Example 1.

Referring to FIG. 10, it could be confirmed that the luminance ratio is reduced with the decrease of the initial capacitance. For example, it could be confirmed that Example 1 and Example 2 having small initial capacitance, showed reduced luminance ratio when compared to the Comparative Example. Accordingly, when a dopant material having a small dipole moment of about 2.0 D or less is included in an emission layer, initial capacitance may be reduced, and accordingly, the reduction of capacitance may be minimized or reduced even after utilizing the light emitting diode for a long time. In some embodiments, the luminance difference after driven in low gradation between a part driven white for a long time and a part driven black for a long time may be reduced when compared to the Comparative Example. In some embodiments, when comparing Example 1 and Example 2, in Example 2 wherein utilized is a material having a small dipole moment (e.g., about 2.0 D or less) as the dopant, and included is a first buffer layer having a HOMO energy level lower than the HOMO energy level of an emission auxiliary layer and substantially equal to or higher than the HOMO energy level of a hole transport host, lower luminance ratio properties are shown in contrast to Example 1.

Accordingly, referring to the results of FIG. 9 and FIG. 10, it could be found that the light emitting diode and a display device including the same according to one or more embodiments, including a dopant material having a small dipole moment of about 2.0 D or less in an emission layer, showed small initial capacitance and insignificant change of capacitance before and after driving. As a result, in one or more embodiments, the light emitting diode and the display device including the same may show reduced RC delay according to the decrease of the capacitance and the small change of capacitance during the utilize for a long time, and may show excellent or suitable light emitting diode properties and excellent or suitable display quality with improved burn-in phenomenon.

In some embodiments, referring to the results of FIG. 9 and FIG. 10, in one or more embodiments, a dopant material having a small dipole moment of about 2.0 D or less is included in an emission layer, and a first buffer layer having a HOMO energy level lower than the HOMO energy level of an emission auxiliary layer and substantially equal to or higher than the HOMO energy level of a hole transport host, is included, and it could be found that the light emitting diode and the display device including the same show small initial capacitance and small change of capacitance before and after driving. Accordingly, the light emitting diode and the display device including the same may show reduced RC delay according to the decrease of the capacitance and the insignificant change of capacitance during the utilize for a long time, and may show excellent or suitable light emitting diode properties and excellent or suitable display quality with improved burn-in phenomenon.

Referring to FIG. 4 again, in one or more embodiments, the light emitting diode ED may include the electron transport region ETR disposed on the emission structure EML. The electron transport region ETR may include at least one selected from among an electron transport layer ETL and an electron injection layer EIL, and may further include auxiliary layers such as a hole blocking layer.

For example, in some embodiments, the electron transport region ETR may have a single layer structure of an electron injection layer EIL or an electron transport layer ETL, or a single layer structure formed utilizing an electron injection material and an electron transport material. Further, in some embodiments, the electron transport region ETR may have a single layer structure formed utilizing a plurality of different materials, or a structure stacked from the emission layer EM of electron transport layer ETL/electron injection layer EIL, hole blocking layer /electron transport layer ETL/electron injection layer EIL, electron transport layer ETL/buffer layer /electron injection layer EIL, and/or the like, without limitation. The thickness of the electron transport region ETR may be, for example, from about 1,000 Å to about 1,500 Å.

The electron transport region ETR may be formed utilizing one or more suitable methods such as a vacuum deposition method, a spin coating method, a casting method, a Langmuir-Blodgett (LB) method, an inkjet printing method, a laser printing method, and/or a laser induced thermal imaging (LITI) method.

The electron transport region ETR may include a compound represented by Formula ET-1.

Formula ET-1

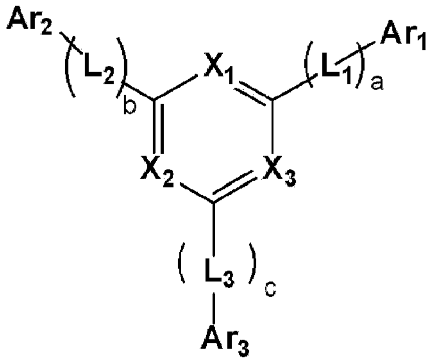

.

In Formula ET-1, at least one selected from among $X_1$ to $X_3$ is N, and the remainder are $CR_a$. $R_a$ may be selected from among hydrogen, deuterium, a substituted or unsubstituted alkyl of 1 to 20 carbon atoms, a substituted or unsubstituted aryl group of 6 to 30 ring-forming carbon atoms, and a substituted or unsubstituted heteroaryl group of 2 to 30 ring-forming carbon atoms. $Ar_1$ to $Ar_3$ may each independently be selected from among hydrogen, deuterium, a substituted or unsubstituted alkyl group of 1 to 20 carbon atoms, a substituted or unsubstituted aryl group of 6 to 30 ring-forming carbon atoms, and a substituted or unsubstituted heteroaryl group of 2 to 30 ring-forming carbon atoms.

In Formula ET-1, "a" to "c" may each independently be an integer of 0 to 10. In Formula ET-1, $L_1$ to $L_3$ may each independently be selected from among a direct linkage, a substituted or unsubstituted arylene group of 6 to 30 ring-forming carbon atoms, and a substituted or unsubstituted heteroarylene group of 2 to 30 ring-forming carbon atoms. In some embodiments, when "a" to "c" are integers of 2 or more, $L_1$ to $L_3$ may each independently be selected from among a substituted or unsubstituted arylene group of 6 to 30 ring-forming carbon atoms and a substituted or unsubstituted heteroarylene group of 2 to 30 ring-forming carbon atoms.

In one or more embodiments, the electron transport region ETR may include an anthracene-based compound. However, embodiments of the present disclosure are not limited thereto, for example, in some embodiments, the electron transport region ETR may include, for example, tris(8-hydroxyquinolinato)aluminum ($Alq_3$), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazolyl-1-ylphenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), 2-(4-biphenylyl)-5-(4-tert-butylphenyl)-1,3,4-oxadiazole (tBu-PBD), bis(2-methyl-8-quinolinolato-N1,O8)-(1,1'-biphenyl-4-olato)aluminum (BAlq), berylliumbis(benzoquinolin-10-olate) ($Bebq_2$), 9,10-di(naphthalene-2-yl)anthracene (ADN), 1,3-bis[3,5-di(pyridin-3-yl)phenyl]benzene (BmPyPhB), diphenyl(4-(triphenylsilyl)phenyl)phosphine oxide (TSPO1), and/or one or more mixtures thereof, without limitation.

In some embodiments, the electron transport region ETR may include at least one selected from among Compounds ET1 to ET36.

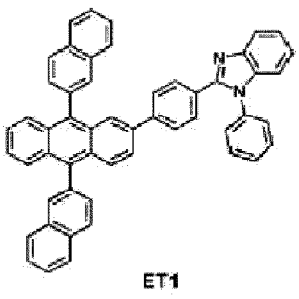

ET1

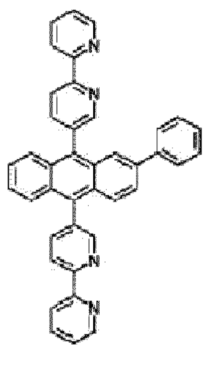

ET2

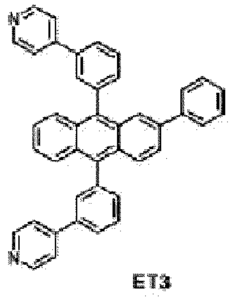

ET3

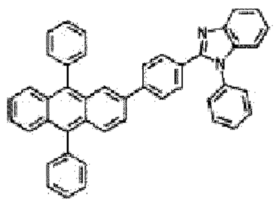

ET4

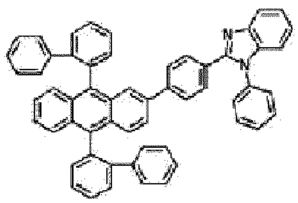

ET5

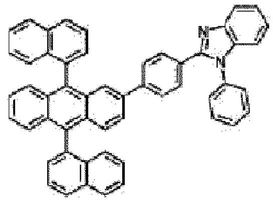

ET6

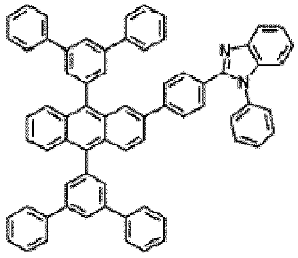

ET7

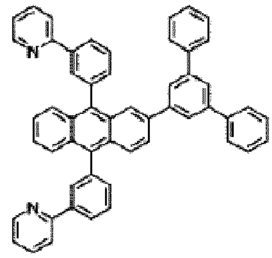

ET8

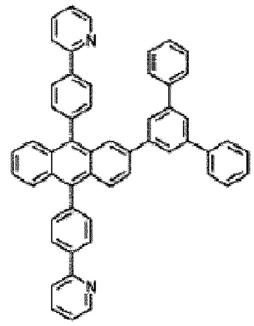

ET9

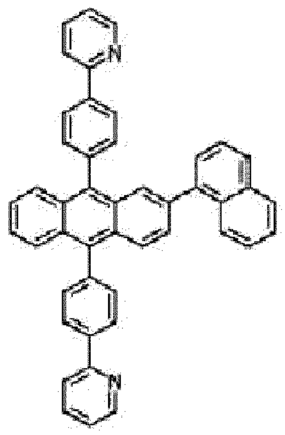

ET10

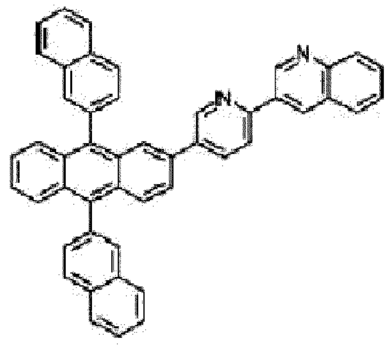

ET11

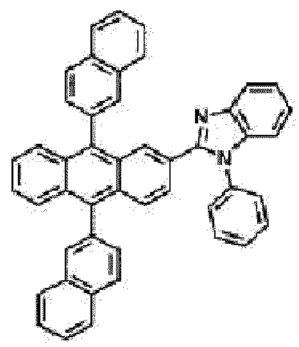

ET12

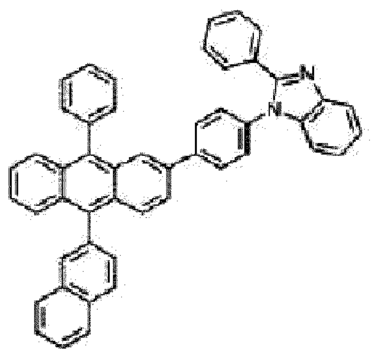

ET13

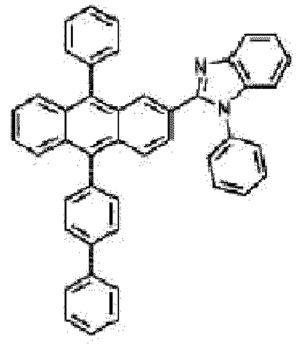

ET14

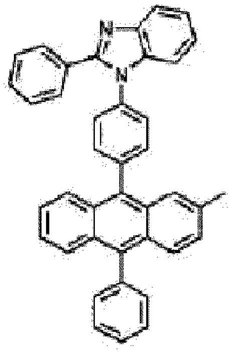

ET15

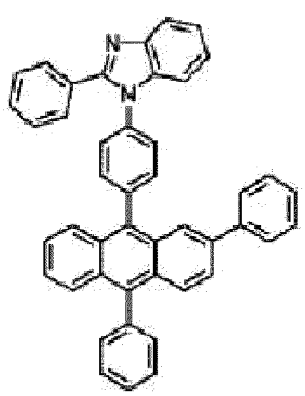

ET16

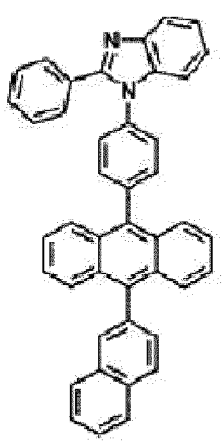

ET17

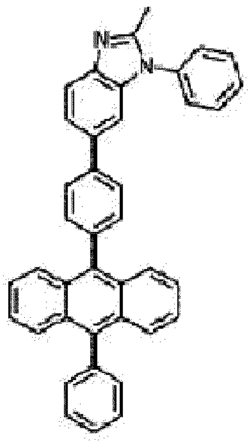

ET18

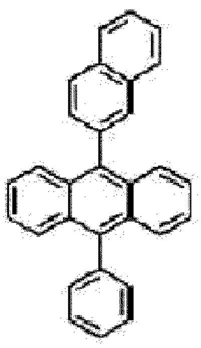

ET19

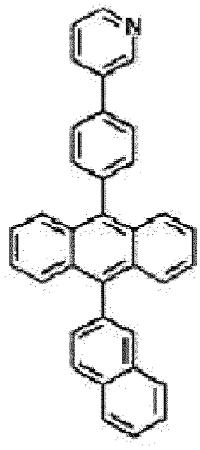

ET20

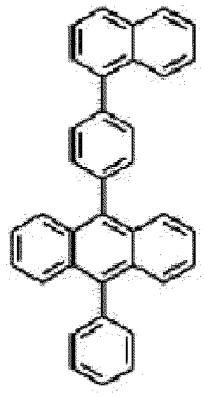

ET21

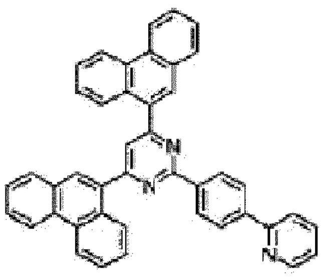

ET22

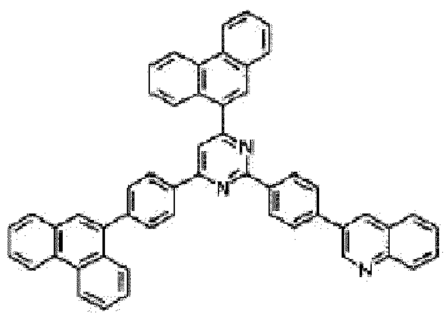

ET23

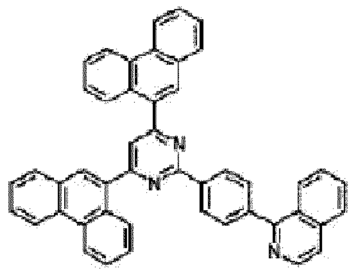

ET24

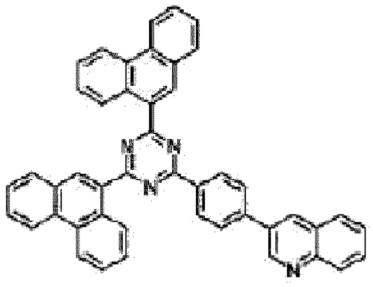

ET25

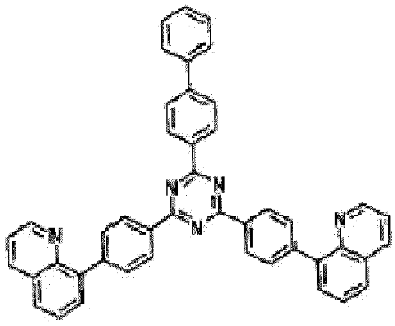

ET26

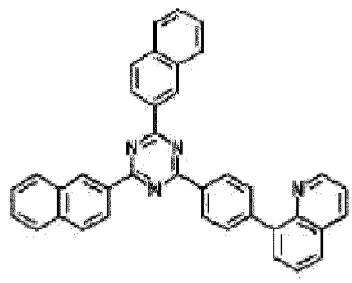

ET27

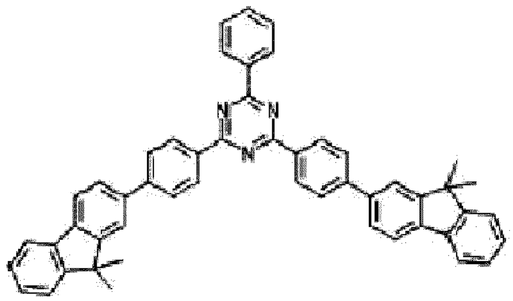

ET28

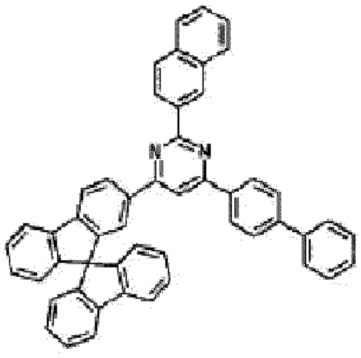

ET29

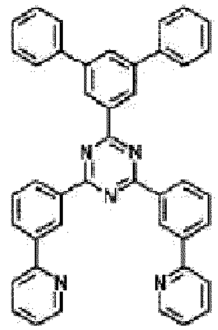

ET30

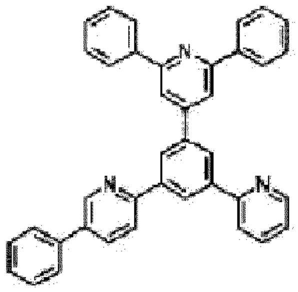

ET31

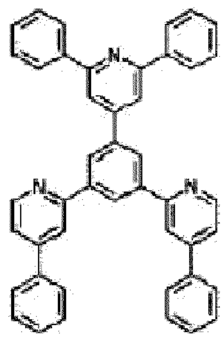

ET32

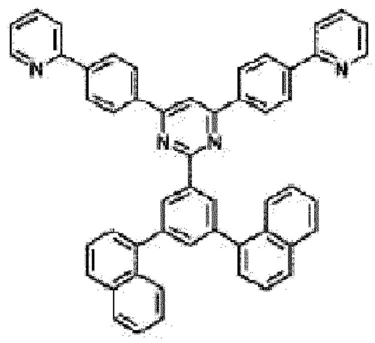

ET33

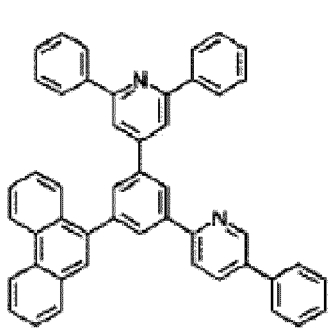

ET34

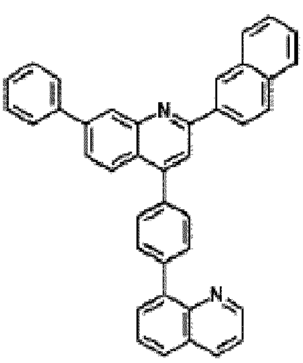

ET35

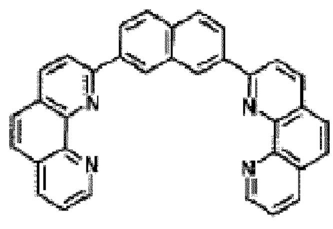

ET36

.

In some embodiments, the electron transport region ETR may include a metal halide such as LiF, NaCl, CsF, RbCl, RbI, CuI and/or KI, a lanthanide metal such as Yb, or a co-depositing material of the metal halide and the lanthanide

metal. For example, the electron transport region ETR may include KI:Yb, RbI:Yb, LiF:Yb, etc., as the co-depositing material. In some embodiments, the electron transport region ETR may utilize a metal oxide such as $Li_2O$ and BaO, and/or 8-hydroxy-lithium quinolate (Liq). However, embodiments of the present disclosure are not limited thereto. In some embodiments, the electron transport region ETR also may be formed utilizing a mixture material of an electron transport material and an insulating organo metal salt. The organo metal salt may be a material having an energy band gap of about 4 eV or more. For example, the organo metal salt may include metal acetates, metal benzoates, metal acetoacetates, metal acetylacetonates, and/or metal stearates.

In some embodiments, the electron transport region ETR may include at least one selected from among 2,9-dimethyl-4,7-diphenyl-1,10-phenanthroline (BCP), diphenyl(4-(triphenylsilyl)phenyl)phosphine oxide (TSPO1) and 4,7-diphenyl-1,10-phenanthroline (Bphen) in addition to the aforementioned materials. However, embodiments of the present disclosure are not limited thereto.

In one or more embodiments, the light emitting diode ED may include an electron transport layer ETL and an electron injection layer EIL stacked in order (e.g., in the stated order) in the electron transport region ETR. For example, in some embodiments, the LUMO energy level of the electron transport layer ETL may be about -1.92 eV. However, embodiments of the present disclosure are not limited thereto, and according to the material utilized in the electron transport region ETR, the energy level value of the electron transport layer ETL or the electron injection layer EIL may change.

Referring to FIG. 4, in one or more embodiments, the emission structure EML may further include a second buffer layer BFL2. The second buffer layer BFL2 may be disposed between the emission layer EM and the electron transport region ETR. In some embodiments, the second buffer layer BFL2 may be disposed between the emission layer EM and the electron transport layer ETL.

In one or more embodiments, the LUMO energy level of the second buffer layer BFL2 may be higher than the LUMO energy level of the electron transport host. In some embodiments, the LUMO energy level of the second buffer layer BFL2 may be higher than the LUMO energy level of the electron transport region ETR. For example, in some embodiments, the LUMO energy level of the second buffer layer BFL2 may be about -1.94 eV to about -1.70 eV.

In some embodiments, the light emitting diode ED may include the second buffer layer BFL2 disposed between the emission layer EM and the electron transport region ETR and has a higher LUMO energy level than the LUMO energy level of the electron transport host of the emission layer EM and the LUMO energy level of the electron transport region ETR, and may prevent or reduce electron accumulation in the emission layer EM and reduce the capacitance of the light emitting diode.

In some embodiments, the light emitting diode ED may include the second buffer layer BFL2 having a higher LUMO energy level than the LUMO energy level of the electron transport host of the emission layer EM and disposed between the emission layer EM and the electron transport region ETR, and may reduce the accumulation phenomenon of electrons in the emission layer EM due to the excessive transfer of electrons from the electron transport region ETR to the emission layer EM.

In one or more embodiments, the light emitting diode ED may include the second buffer layer BFL2 having a higher LUMO energy level than the LUMO energy level of the electron transport host of the emission layer EM and may reduce initial capacitance.

FIG. 11 shows an energy diagram in a light emitting diode according to one or more embodiments of the present disclosure. FIG. 11 shows energy diagrams of a hole transport region HTR, an emission auxiliary layer A-EM, a first buffer layer BFL1, a hole transport host HT, an electron transport host ET, a dopant DPT, a second buffer layer BFL2, and an electron transport layer ETL. In each energy diagram represented by a square, a side having a lower energy level corresponds to a HOMO energy level, and a side having a higher energy level corresponds to a LUMO energy level. Meanwhile, in FIG. 11, each HOMO energy level and each LUMO energy level are shown, but these are example values in the light emitting diode according to some embodiments.

Referring to FIG. 11, the LUMO energy level of the second buffer layer BFL2 corresponds to about -1.78 eV, and the LUMO energy level of the electron transport host ET corresponds to about -1.94 eV. For example, in some embodiments, the light emitting diode ED may include a second buffer layer BFL2 having a higher LUMO energy level than the LUMO energy level of the electron transport host ET and the LUMO energy level of the electron transport layer ETL.

In some embodiments, in the light emitting diode ED, shown in FIG. 4, the LUMO energy level of the electron transport layer ETL may be lower than the LUMO energy level of the second buffer layer BFL2. In some embodiments, the LUMO energy level of the electron transport layer ETL may be substantially equal to or higher than the LUMO energy level of the electron transport host. In some embodiments, in the light emitting diode ED, the electron transport layer ETL may have a relatively deep LUMO energy level when compared to the second buffer layer BFL2.

In one or more embodiments, the gap between the LUMO energy level of the electron transport host and the LUMO energy level of the second buffer layer BFL2 may be greater than the gap between the LUMO energy level of the electron transport host and the LUMO energy level of the electron transport layer ETL. However, embodiments of

the present disclosure are not limited thereto.

FIG. 12 is a diagram showing the capacitance of a light emitting diode according to the LUMO energy level of a second buffer layer, and FIG. 13 is a diagram showing the capacitance of a light emitting diode according to the LUMO energy level of an electron transport layer.

The LUMO energy level of the second buffer layer, represented in FIG. 12 is shown in Table 1.

**[Table 1]**

| Division | LV1-BF | LV2-BF | LV3-BF |
|---|---|---|---|
| LUMO energy level (eV) | -1.83 | -1.78 | -1.73 |

Referring to FIG. 12, it could be found that capacitance decreases with the increase of the LUMO energy level of the second buffer layer.

The LUMO energy level of the electron transport layer, represented in FIG. 13 is shown in Table 2.

**[Table 2]**

| Division | LV1 | LV2 | LV3 |
|---|---|---|---|
| LUMO energy level (eV) | -1.87 | -1.92 | -1.97 |

Referring to FIG. 13, it could be found that capacitance decreases with the decrease of the LUMO energy level of the electron transport layer.

Accordingly, referring to the results of FIG. 12 and FIG. 13, in the light emitting diode ED of one or more embodiments, it could be found that the initial capacitance decreases with the increase of the LUMO energy level of the second buffer layer BFL2 and the decrease of the LUMO energy level of the electron transport layer ETL. Accordingly, in one or more embodiments, the light emitting diode may include the second buffer layer having a higher LUMO energy level than the LUMO energy level of the electron transport host of the emission layer and include the electron transport layer having a higher LUMO energy level than the LUMO energy level of the electron transport host of the emission layer, and may show reduced capacitance. Accordingly, considering the relation of the capacitance and luminance ratio, shown in FIG. 10, etc., the light emitting diode including the second buffer layer and electron transport layer having the above-described relation on the LUMO energy level, may show improved diode properties and display quality.

In one or more embodiments, the light emitting diode may include a dopant having a dipole moment of about 2.0 D or less in an emission layer. The initial capacitance of the light emitting diode may be reduced, and the change of capacitance after utilized for a long time may be reduced. The light emitting diode shows improved properties of reducing the deterioration defects of emission properties. In some embodiments, the light emitting diode may include a first buffer layer disposed between an emission auxiliary layer and an emission layer and having a lower HOMO energy level than the emission auxiliary layer, may optimize or improve the HOMO energy level of the first buffer layer to prevent or reduce hole accumulation in the emission layer, and may maintain excellent or suitable diode properties even driving for a long time.

In some embodiments, the display device may include the light emitting diode of one or more embodiments of the present disclosure and may improve burn-in defects at low gradation, generated during driving for a long time, thereby showing excellent or suitable display quality.

In one or more embodiments, the light emitting diode may include a dopant material having small dipole moment (e.g., about 2.0 D or less), and may show excellent or suitable diode properties even after driving for a long time.

In one or more embodiments, the display device may include a light emitting diode including a dopant material having small dipole moment (e.g., about 2.0 D or less), and may show excellent or suitable display quality even after driving for a long time.

As discussed, embodiments may provide a light emitting diode comprising: a first electrode; a hole transport region on the first electrode; an emission auxiliary layer on the hole transport region; a first buffer layer on the emission auxiliary layer; an emission layer on the first buffer layer and comprising a hole transport host, an electron transport host, and a dopant; a second buffer layer on the emission layer; an electron transport region on the second buffer layer; and a second electrode on the electron transport region, wherein a dipole moment of the dopant is about 2.0 Debye, D, or less.

The dipole moment of the dopant included in the emission layer may be about 1.80 D or less.

The dopant may be an organometallic complex including Pt as a central metal. In some embodiments, the dopant may comprise a compound represented by Formula M (as shown above).

The hole transport host may comprise a compound represented by Formula HTH-1 (as shown above).

The hole transport host may comprise a compound represented by Formula HTH-1 (as shown above).
The electron transport host may comprise a compound represented by Formula ETH-1 (as shown above).
The hole transport region may comprise a compound represented by Formula H-1 (as shown above).
The electron transport region may comprise a compound represented by Formula ET-1 (as shown above).
Embodiments may provide a display device comprising a plurality of light emitting diodes configured to emit different wavelength regions of light, wherein each of the plurality of light emitting diodes comprises: a first electrode; a hole transport region on the first electrode; an emission structure on the hole transport region and comprising an emission layer; an electron transport region on the emission structure; and a second electrode on the electron transport region, wherein the emission layer, in at least one emission structure in the plurality of light emitting diodes, comprises a hole transport host, an electron transport host, and a dopant, and wherein a dipole moment of the dopant is about 2.0 D or less.
As used herein, the term "substantially," "about," and similar terms are used as terms of approximation and not as terms of degree, and are intended to account for the inherent deviations in measured or calculated values that would be recognized by those of ordinary skill in the art. "About," "substantially," or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within $\pm$ 30%, 20%, 10%, 5% of the stated value.
Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this disclosure is intended to include all higher numerical limitations subsumed therein. Accordingly, Applicant reserves the right to amend this disclosure, including the claims, to expressly recite any sub-range subsumed within the ranges expressly recited herein.
The light emitting diode, the display device, or any other relevant devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.
Although the embodiments of the present disclosure have been described, it is understood that the present disclosure should not be limited to these embodiments, but one or more suitable changes and modifications can be made by one ordinary skilled in the art within the scope of the present disclosure as hereinafter claimed and equivalent thereof.

## Claims

**1.** A light emitting diode comprising:

a first electrode;
a hole transport region on the first electrode;
an emission auxiliary layer on the hole transport region;
a first buffer layer on the emission auxiliary layer;
an emission layer on the first buffer layer and comprising a hole transport host, an electron transport host, and a dopant;
a second buffer layer on the emission layer;
an electron transport region on the second buffer layer; and

a second electrode on the electron transport region,
wherein a dipole moment of the dopant is about 2.0 Debye, D, or less.

2. The light emitting diode of claim 1, wherein a highest occupied molecular orbital, HOMO, energy level of the first buffer layer is lower than a HOMO energy level of the emission auxiliary layer.

3. The light emitting diode of claim 2, wherein the HOMO energy level of the first buffer layer is substantially equal to or higher than a HOMO energy level of the hole transport host.

4. The light emitting diode of any one of claims 1 to 3, wherein a HOMO energy level of the first buffer layer is about -4.97 eV to about -4.80 eV.

5. The light emitting diode of any one of claims 1 to 4, wherein a lowest unoccupied molecular orbital, LUMO, energy level of the second buffer layer is higher than a LUMO energy level of the electron transport host.

6. The light emitting diode of any one of claims 1 to 5, wherein a LUMO energy level of the second buffer layer is about -1.94 eV to about -1.70 eV.

7. The light emitting diode of any one of claims 1 to 6, wherein the dopant is an organometallic complex comprising platinum, Pt, as a central metal.

8. The light emitting diode of any one of claims 1 to 7, wherein the emission layer is configured to emit green light.

9. The light emitting diode of any one of claims 1 to 8, wherein the first buffer layer is directly between the emission auxiliary layer and the emission layer, and the second buffer layer is directly on the emission layer.

10. A display device comprising

a plurality of light emitting diodes configured to emit different wavelength regions of light,
wherein each of the plurality of light emitting diodes comprises:

a first electrode;
a hole transport region on the first electrode;
an emission structure on the hole transport region and comprising an emission layer;
an electron transport region on the emission structure; and
a second electrode on the electron transport region,
wherein the emission layer, in at least one emission structure in the plurality of light emitting diodes, comprises a hole transport host, an electron transport host, and a dopant, and
wherein a dipole moment of the dopant is about 2.0 D or less.

11. The display device of claim 10, wherein the at least one the emission structure further comprises:

an emission auxiliary layer on the hole transport region;
a first buffer layer between the emission auxiliary layer and the emission layer; and
a second buffer layer between the emission layer and the electron transport region.

12. The display device of claim 11, wherein a HOMO energy level of the first buffer layer is substantially equal to or higher than a HOMO energy level of the hole transport host and is lower than a HOMO energy level of the emission auxiliary layer.

13. The display device of claim 12, wherein a difference between the HOMO energy level of the first buffer layer and the HOMO energy level of the emission auxiliary layer is greater than a difference between the HOMO energy level of the first buffer layer and the HOMO energy level of the hole transport host.

14. The display device of any one of claims 11 to 13, wherein a LUMO energy level of the second buffer layer is higher than a LUMO energy level of the electron transport host.

15. The display device of claim 14, wherein a LUMO energy level of the electron transport region is substantially equal

to or higher than the LUMO energy level of the electron transport host.

FIG. 1

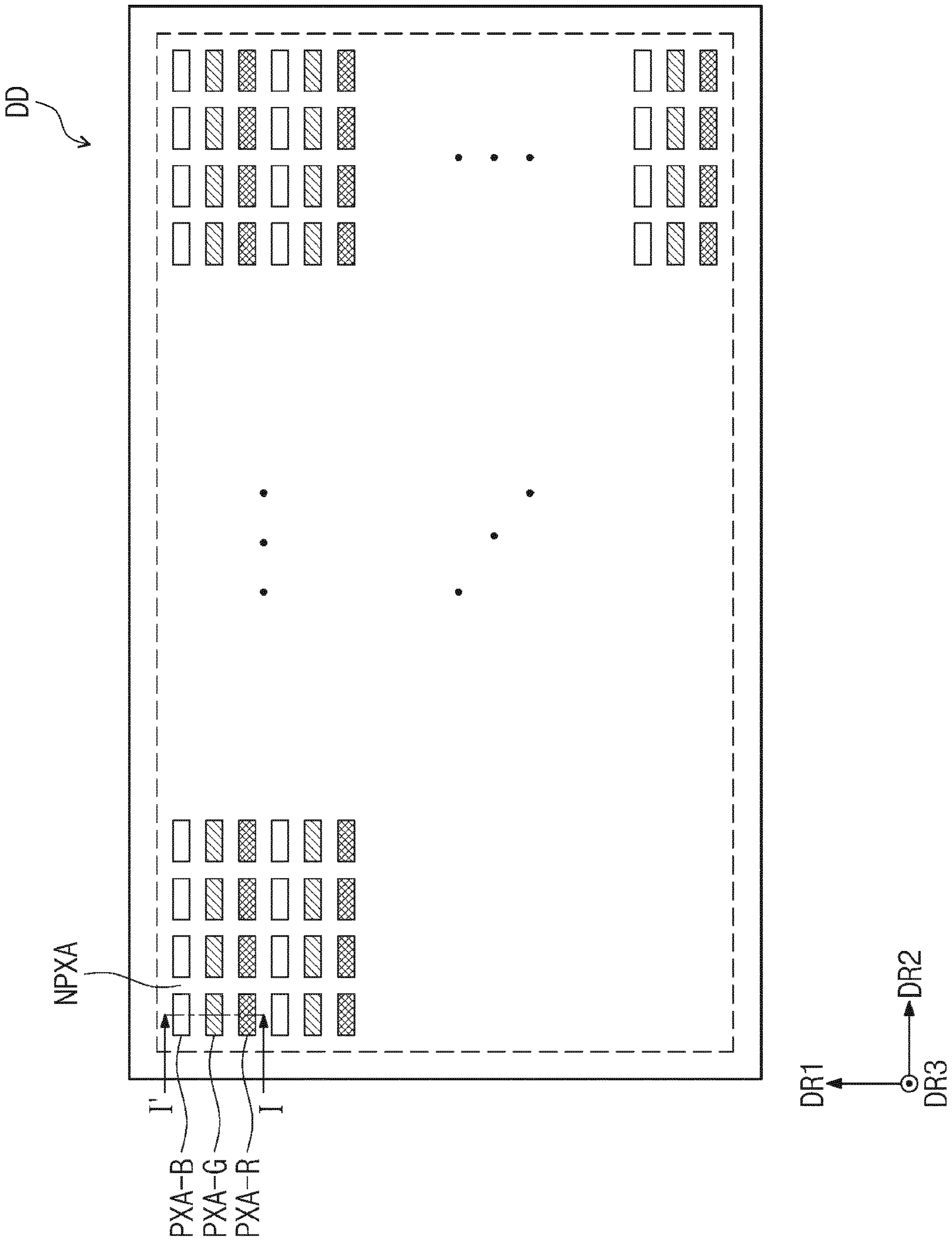

FIG. 2

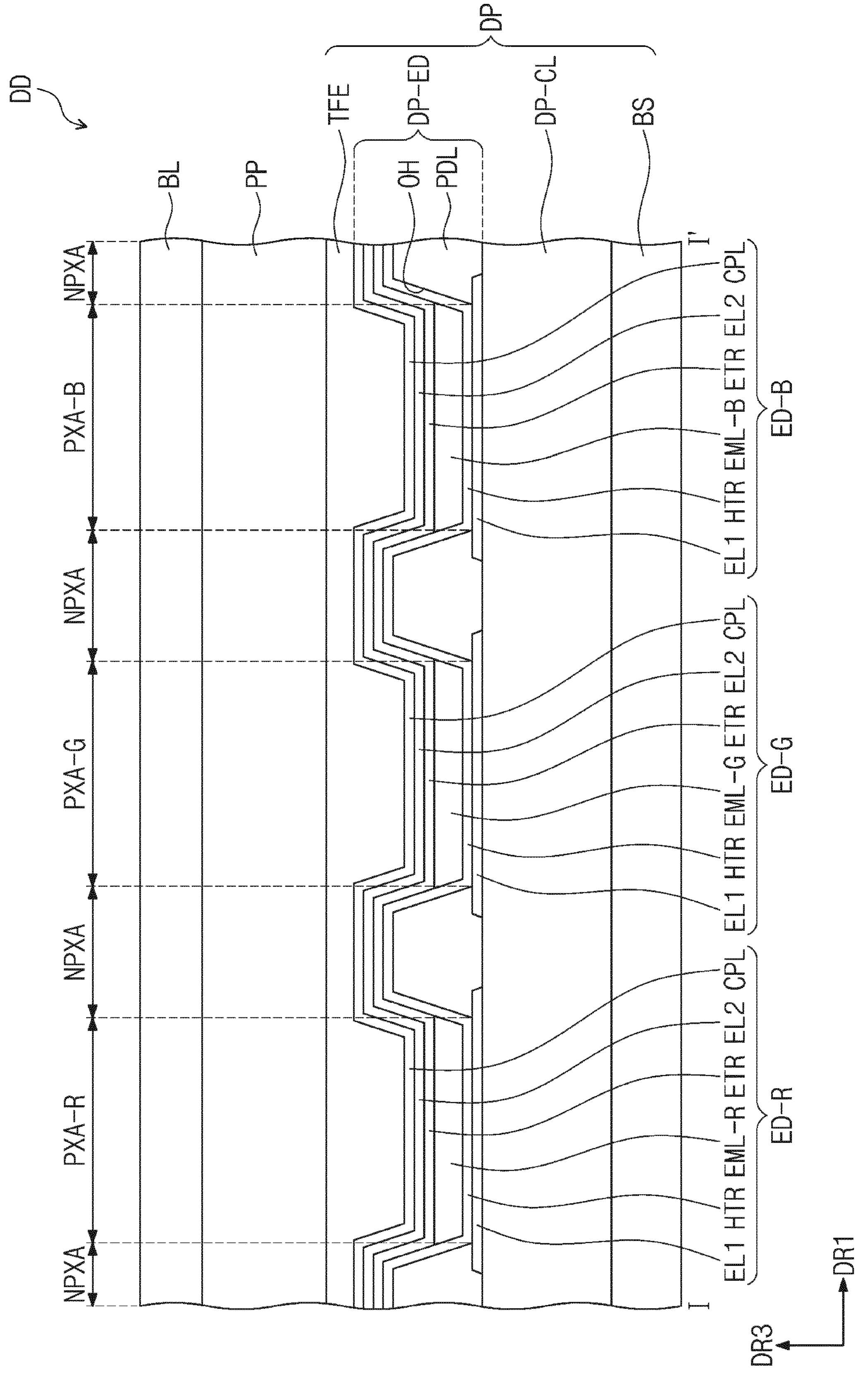
DD
DP
TFE
DP-ED
DP-CL
BS
BL
PP
OH
PDL
NPXA
PXA-B
PXA-G
PXA-R
I'
I
EL1 HTR EML-B ETR EL2 CPL
ED-B
EL1 HTR EML-G ETR EL2 CPL
ED-G
EL1 HTR EML-R ETR EL2 CPL
ED-R
DR1
DR3

FIG. 3A

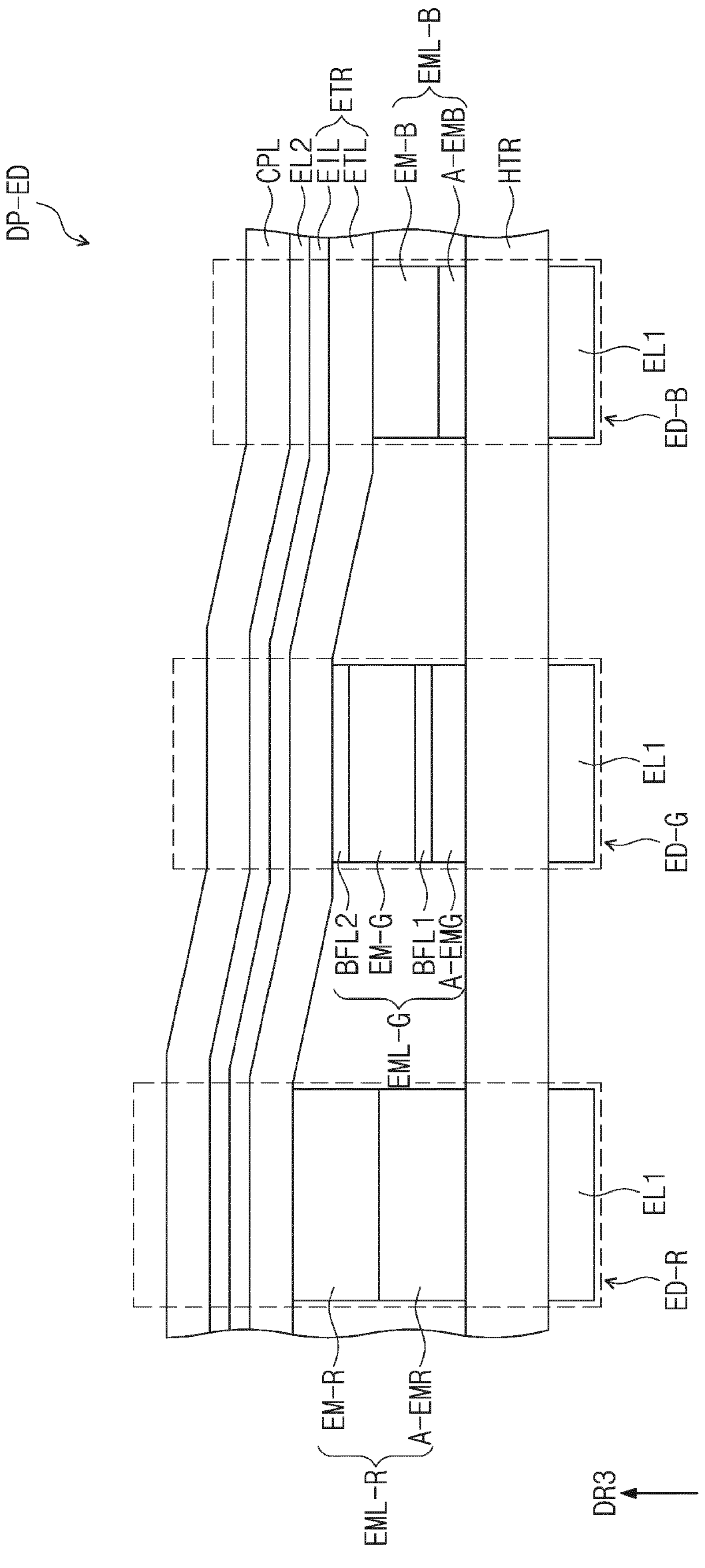
DP-ED
CPL
EL2
EIL
ETL
ETR
EM-B
A-EMB
EML-B
HTR
EL1
ED-B
EL1
ED-G
BFL2
EM-G
BFL1
A-EMG
EML-G
EL1
ED-R
EM-R
A-EMR
EML-R
DR3

FIG. 3B

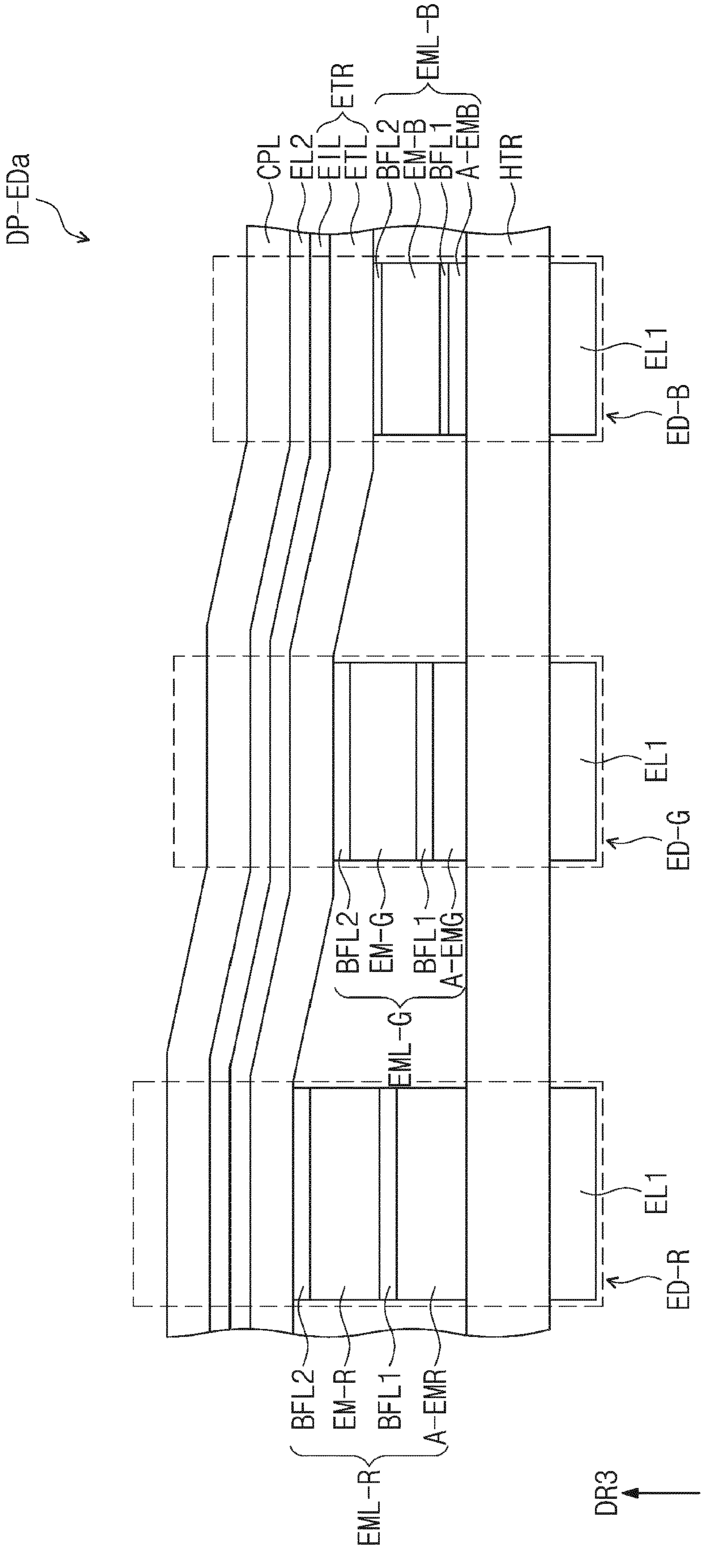
DP-EDa
CPL
EL2
EIL
ETL
ETR
BFL2
EM-B
BFL1
A-EMB
EML-B
HTR
EL1
ED-B
ED-G
ED-R
BFL2
EM-G
BFL1
A-EMG
EML-G
BFL2
EM-R
BFL1
A-EMR
EML-R
DR3

FIG. 4

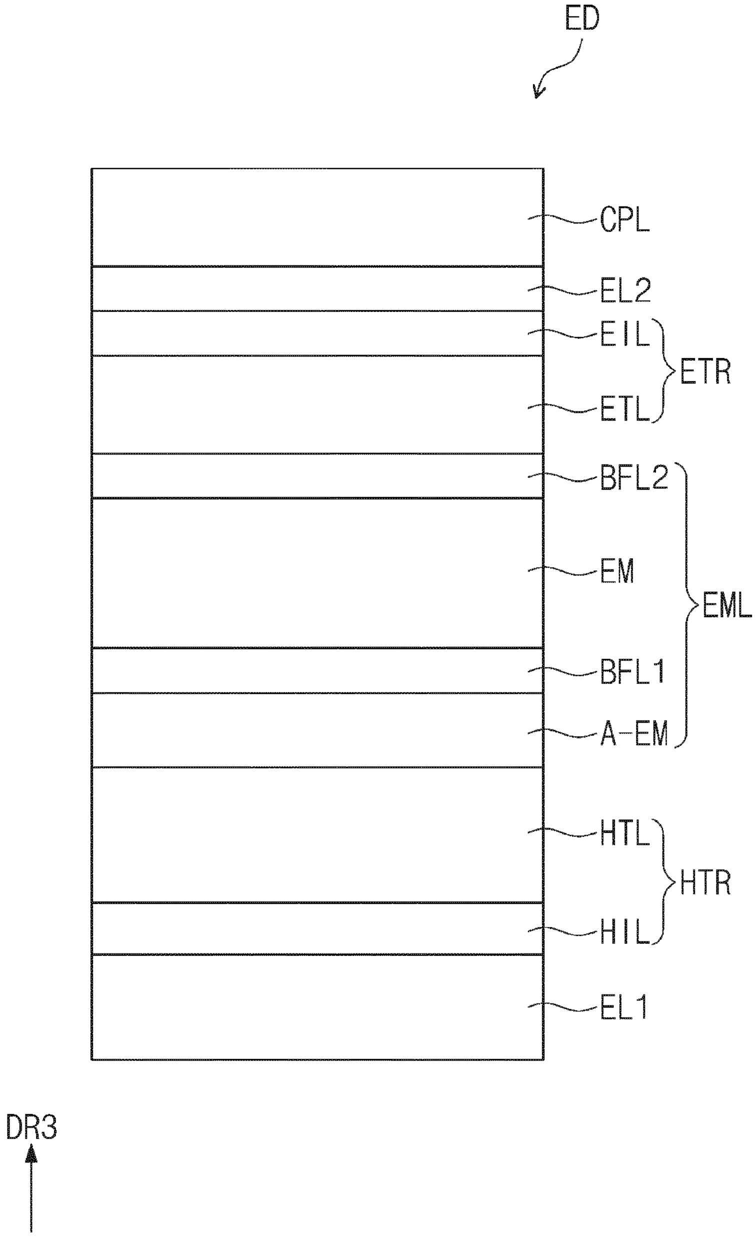

FIG. 5

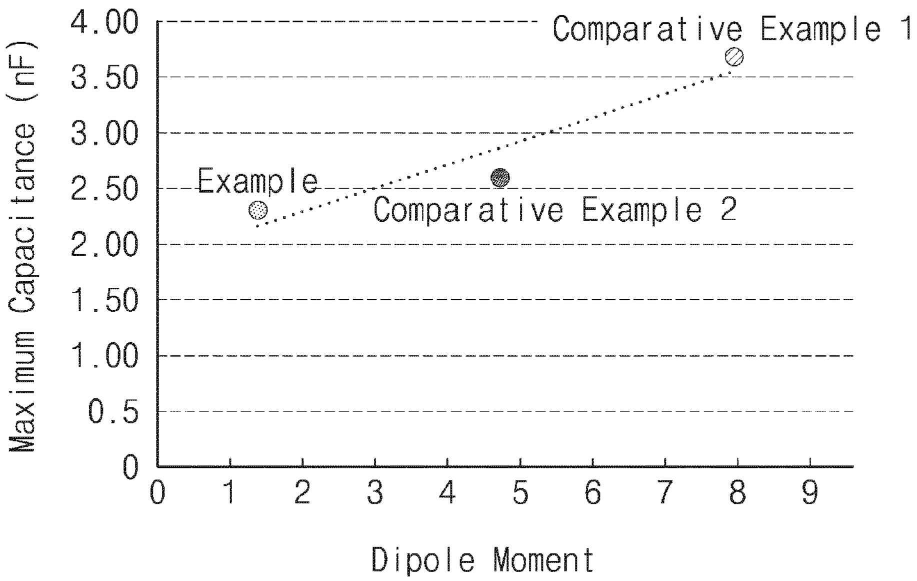
Maximum Capacitance (nF)
4.00
3.50
3.00
2.50
2.00
1.50
1.00
0.5
0
0 1 2 3 4 5 6 7 8 9
Dipole Moment
Comparative Example 1
Example
Comparative Example 2

FIG. 6A

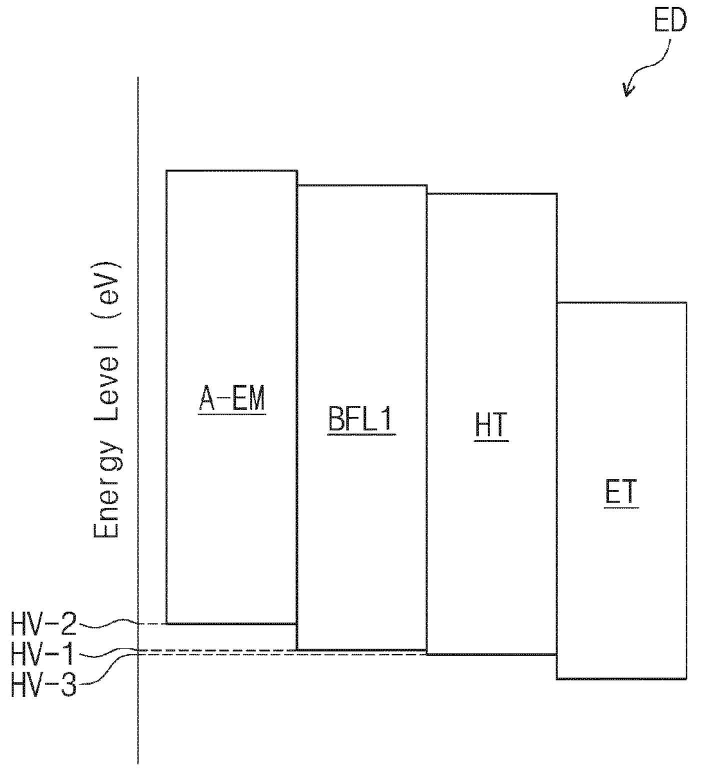
ED
Energy Level (eV)
A-EM
BFL1
HT
ET
HV-2
HV-1
HV-3

FIG. 6B

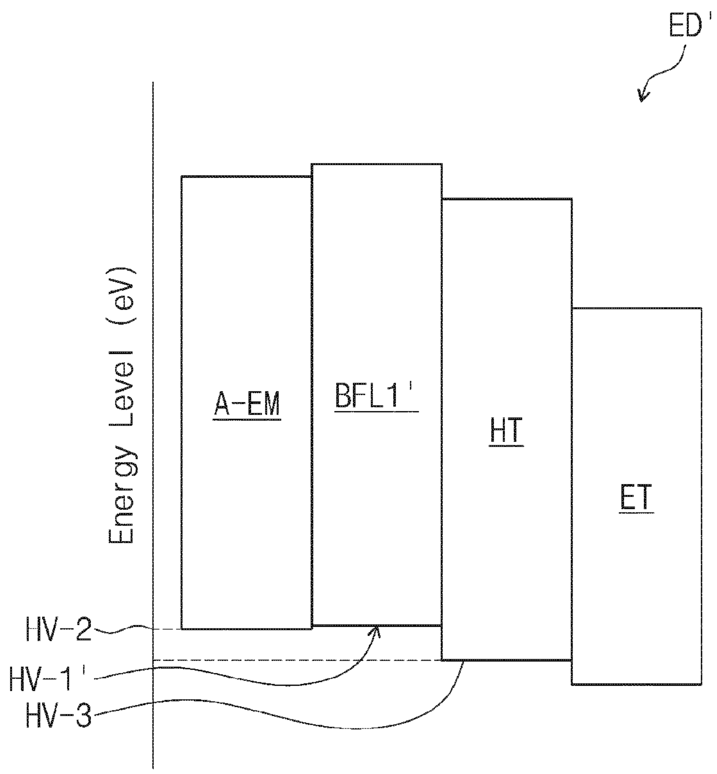
ED'
Energy Level (eV)
A-EM
BFL1'
HT
ET
HV-2
HV-1'
HV-3

FIG. 7

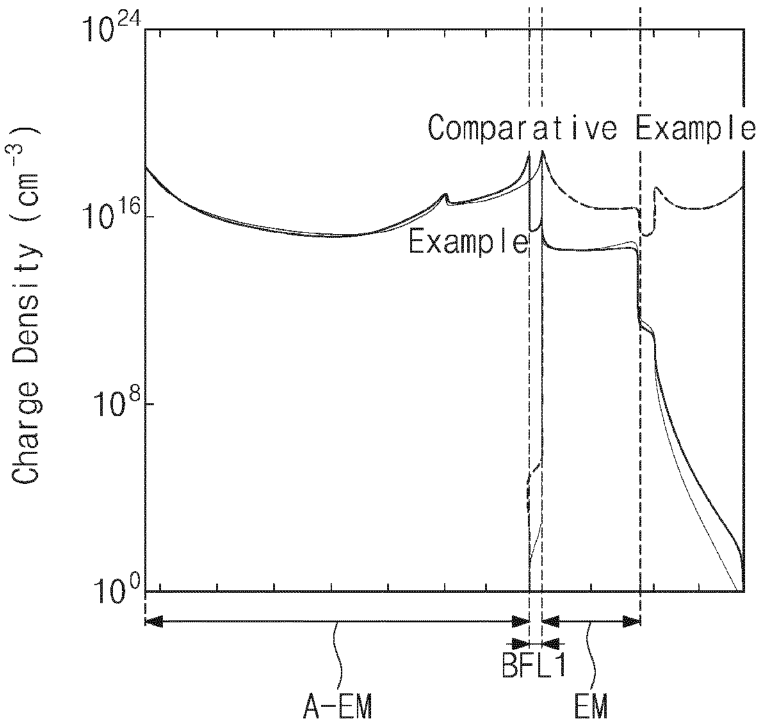

Charge Density (cm-3)
10^24
10^16
10^8
10^0
Comparative Example
Example
A-EM
BFL1
EM


FIG. 8

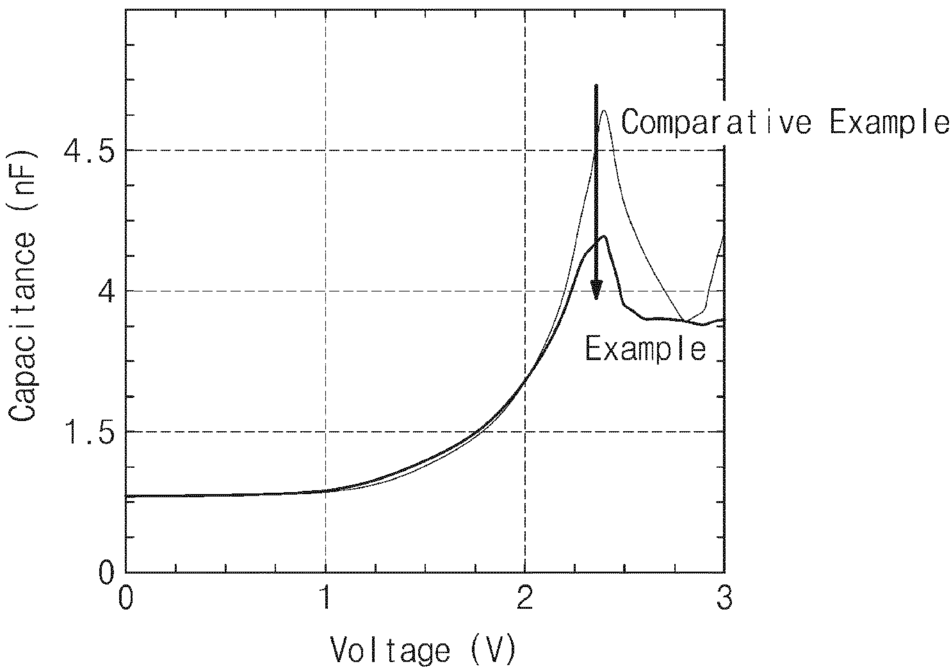

Capacitance (nF)
4.5
4
1.5
0
0
1
2
3
Voltage (V)
Comparative Example
Example

FIG. 9

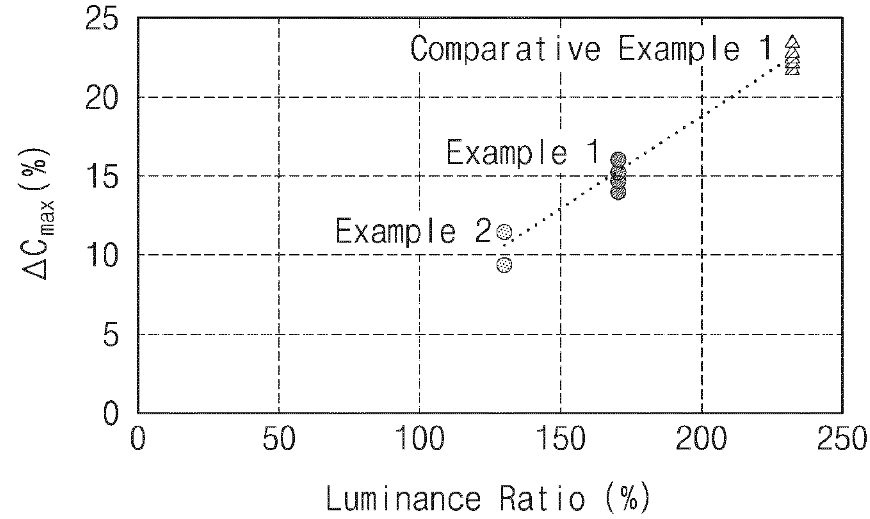

25
20
15
10
5
0
0
50
100
150
200
250
ΔCmax (%)
Luminance Ratio (%)
Comparative Example 1
Example 1
Example 2


FIG. 10

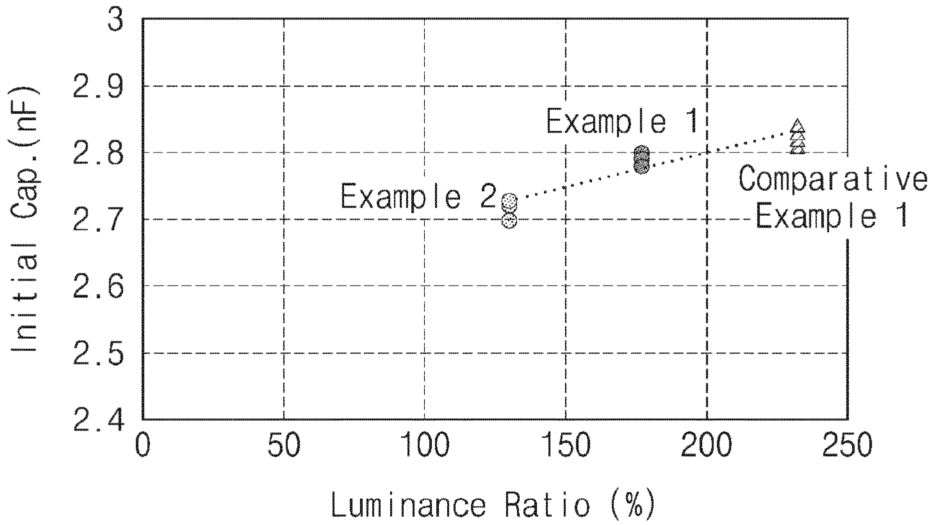

3
2.9
2.8
2.7
2.6
2.5
2.4
0
50
100
150
200
250
Initial Cap.(nF)
Luminance Ratio (%)
Example 1
Example 2
Comparative Example 1

FIG. 11

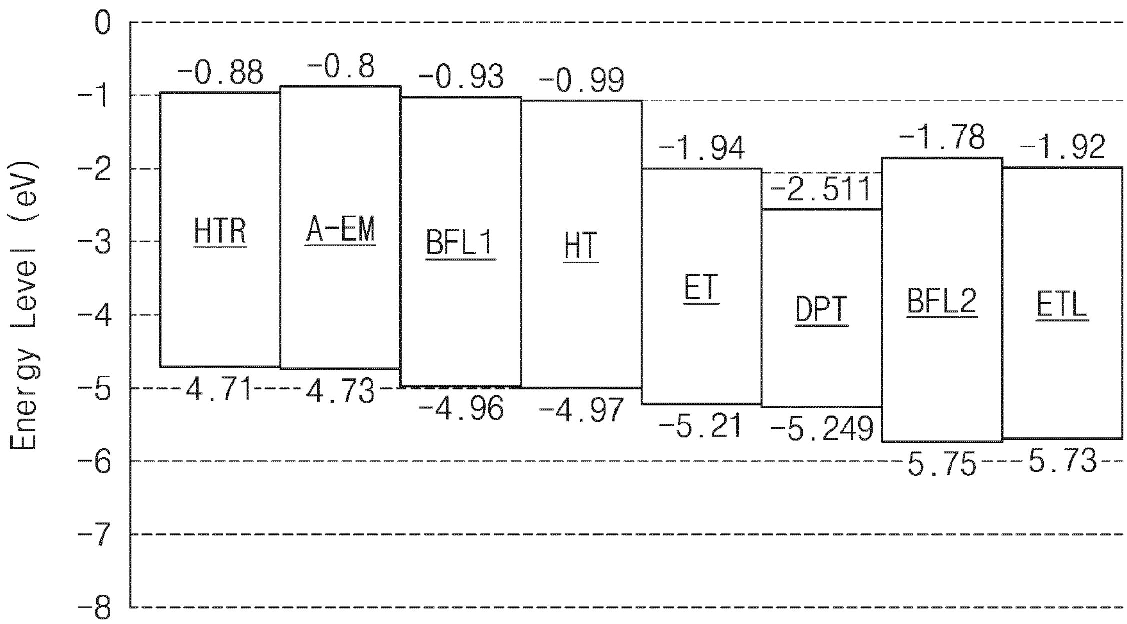
Energy Level (eV)
0
-1
-2
-3
-4
-5
-6
-7
-8
HTR
A-EM
BFL1
HT
ET
DPT
BFL2
ETL
-0.88
-0.8
-0.93
-0.99
-1.94
-2.511
-1.78
-1.92
-4.71
-4.73
-4.96
-4.97
-5.21
-5.249
5.75
5.73

FIG. 12

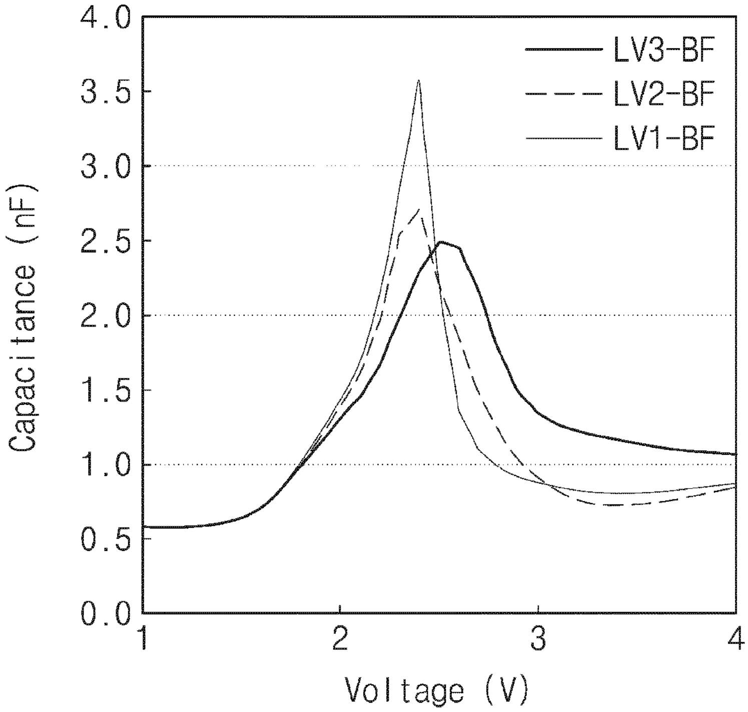
4.0
3.5
3.0
2.5
2.0
1.5
1.0
0.5
0.0
1
2
3
4
Capacitance (nF)
Voltage (V)
LV3-BF
LV2-BF
LV1-BF

FIG. 13

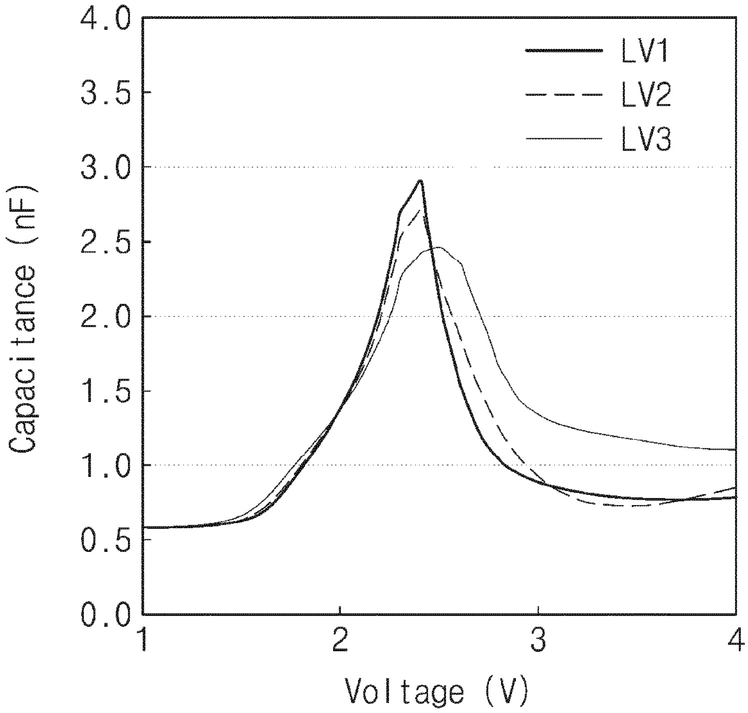
4.0
3.5
3.0
2.5
2.0
1.5
1.0
0.5
0.0
1
2
3
4
Capacitance (nF)
Voltage (V)
LV1
LV2
LV3

Europäisches Patentamt
European Patent Office
Office européen des brevets

# EUROPEAN SEARCH REPORT

Application Number
EP 23 17 8303

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>Y | US 2021/376252 A1 (SUN JINWON [KR] ET AL) 2 December 2021 (2021-12-02)<br>* paragraphs [0011], [0012], [0088] *<br>* paragraphs [0031] - [0041] *<br>* paragraphs [0135], [0287], [0269] *<br>* figure 1 *<br>* claims 6,16 *<br>* page 54 *<br>* compound PD14 *<br>----- | 1,9<br><br>2-8 | INV.<br>H10K50/11<br><br>ADD.<br>H10K101/00<br>H10K50/18 |
| T | KIM YOUNG-HOON ET AL: "Molecular-Scale Strategies to Achieve High Efficiency and Low Efficiency Roll-off in Simplified Solution-Processed Organic Light-Emitting Diodes",<br>ADVANCED FUNCTIONAL MATERIALS, [Online] vol. 30, no. 46, 9 September 2020 (2020-09-09), page 2005292, XP055974687, DE<br>ISSN: 1616-301X, DOI: 10.1002/adfm.202005292<br>Retrieved from the Internet: URL:https://onlinelibrary.wiley.com/doi/full-xml/10.1002/adfm.202005292><br>[retrieved on 2023-09-26]<br>* pages 1,3 *<br>----- | 1-12,14, 15 | TECHNICAL FIELDS SEARCHED (IPC)<br><br>H10K |
| X<br><br>Y | US 2022/173339 A1 (LEE YOONKYOO [KR] ET AL) 2 June 2022 (2022-06-02)<br>* paragraphs [0074], [0087], [0116] *<br>* paragraphs [0095], [0098], [0193] *<br>* figure 2 *<br>* page 40 *<br>* compounds M-a12 *<br>-----<br>-/-- | 10,11<br><br>12,14,15 | |

The present search report has been drawn up for all claims

1

| Place of search | Date of completion of the search | Examiner |
|---|---|---|
| Munich | 29 September 2023 | Pfattner, Raphael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches Patentamt
European Patent Office
Office européen des brevets

# EUROPEAN SEARCH REPORT

Application Number
EP 23 17 8303

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2010/140602 A1 (SOTOYAMA WATARU [JP]) 10 June 2010 (2010-06-10)<br>* paragraph [0085] *<br>* page 75 *<br>* compound G3 *<br>----- | 7,8 | |
| Y | US 2016/149150 A1 (SEO JIHOON [KR] ET AL) 26 May 2016 (2016-05-26)<br>* paragraphs [0102], [0104], [0105] *<br>* paragraphs [0111], [0112] *<br>----- | 2,3,5, 12,14,15 | |
| Y | US 2007/034859 A1 (TIERNEY BRIAN [GB] ET AL) 15 February 2007 (2007-02-15)<br>* paragraph [0049] *<br>----- | 4 | |
| Y | US 2021/328155 A1 (CHO SANG-HEE [KR] ET AL) 21 October 2021 (2021-10-21)<br>* paragraph [0115] *<br>----- | 6 | |

TECHNICAL FIELDS SEARCHED (IPC)

1

The present search report has been drawn up for all claims

| Place of search | Date of completion of the search | Examiner |
|---|---|---|
| Munich | 29 September 2023 | Pfattner, Raphael |

EPO FORM 1503 03.82 (P04C01)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

page 2 of 2

# ANNEX TO THE EUROPEAN SEARCH REPORT ON EUROPEAN PATENT APPLICATION NO.

EP 23 17 8303

This annex lists the patent family members relating to the patent documents cited in the above-mentioned European search report. The members are as contained in the European Patent Office EDP file on
The European Patent Office is in no way liable for these particulars which are merely given for the purpose of information.

29-09-2023

| Patent document cited in search report | Publication date | Patent family member(s) | Publication date |
|---|---|---|---|
| US 2021376252 A1 | 02-12-2021 | CN 113690376 A | 23-11-2021 |
| | | EP 3913699 A1 | 24-11-2021 |
| | | EP 4240130 A2 | 06-09-2023 |
| | | KR 20210143379 A | 29-11-2021 |
| | | US 2021376252 A1 | 02-12-2021 |
| US 2022173339 A1 | 02-06-2022 | CN 114583073 A | 03-06-2022 |
| | | KR 20220078000 A | 10-06-2022 |
| | | US 2022173339 A1 | 02-06-2022 |
| US 2010140602 A1 | 10-06-2010 | JP 5740075 B2 | 24-06-2015 |
| | | JP 2010140950 A | 24-06-2010 |
| | | US 2010140602 A1 | 10-06-2010 |
| US 2016149150 A1 | 26-05-2016 | KR 20160063513 A | 07-06-2016 |
| | | US 2016149150 A1 | 26-05-2016 |
| US 2007034859 A1 | 15-02-2007 | AT 517442 T | 15-08-2011 |
| | | CN 1762062 A | 19-04-2006 |
| | | EP 1604410 A2 | 14-12-2005 |
| | | HK 1085053 A1 | 11-08-2006 |
| | | JP 4405504 B2 | 27-01-2010 |
| | | JP 2006521008 A | 14-09-2006 |
| | | KR 20050109584 A | 21-11-2005 |
| | | US 2007034859 A1 | 15-02-2007 |
| | | US 2009215223 A1 | 27-08-2009 |
| | | WO 2004084260 A2 | 30-09-2004 |
| US 2021328155 A1 | 21-10-2021 | CN 106068267 A | 02-11-2016 |
| | | EP 3119767 A1 | 25-01-2017 |
| | | JP 2017510071 A | 06-04-2017 |
| | | KR 20150108330 A | 25-09-2015 |
| | | TW 201600519 A | 01-01-2016 |
| | | US 2017117485 A1 | 27-04-2017 |
| | | US 2021328155 A1 | 21-10-2021 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 1020220070204